# EUROPEAN PATENT SPECIFICATION

(11) **EP 2 881 198 B1**
(45) Date of publication and mention of the grant of the patent: **25.03.2020**
(21) Application number: 13824908.1
(22) Date of filing: 02.08.2013
(51) Int. Cl.: B22F 1/00, B22F 9/24, B22F 9/30, B82Y 30/00, H01B 1/02, H05K 1/09, B22F 3/10

(54) **PROCESS FOR PRODUCING COATED FINE SILVER PARTICLES AND PASTE COMPRISING SAID COATED FINE SILVER PARTICLES**
VERFAHREN ZUR HERSTELLUNG BESCHICHTETER FEINER SILBERPARTIKEL UND PASTE UMFASSEND GENANNTE BESCHICHTETE SILBERFEINPARTIKEL
PROCÉDÉ DE PRODUCTION DE FINES PARTICULES D'ARGENT REVÊTUES ET PÂTE COMPRENANT LESDITES FINES PARTICULES D'ARGENT REVÊTUES

(30) Priority: 02.08.2012 JP 2012172254; 21.08.2012 JP 2012182765
(43) Date of publication of application: 10.06.2015
(73) Proprietor: National University Corporation Yamagata University, Yamagata 990-8560 (JP)
(72) Inventor: KURIHARA, Masato, Yamagata-shi Yamagata 990-8560 (JP); KON, Hiroki, Yamagata-shi Yamagata 990-8560 (JP)
(74) Representative: Mewburn Ellis LLP
(86) International application number: PCT/JP2013/071051
(87) International publication number: WO 2014/021461

(56) References cited:
- EP-A1- 1 952 918
- EP-A1- 2 017 016
- EP-A2- 1 646 095
- JP-A- 2009 116 452
- JP-A- 2009 270 146
- JP-A- 2009 270 146
- JP-A- 2010 265 543
- JP-A- 2010 500 475
- JP-A- 2011 166 100
- JOOYOUNG SONG ET AL: "Aqueous Synthesis of Silver Nanoparticle Embedded Cationic Polymer Nanofibers and Their Antibacterial Activity", ACS APPLIED MATERIALS AND INTERFACES, vol. 4, no. 1, 25 January 2012 (2012-01-25), pages 460-465, XP055279445, US ISSN: 1944-8244, DOI: 10.1021/am201563t
- ADEYINKA AINA ET AL: "Dissolution Behavior of Poly Vinyl Alcohol in Water and its Effect on the Physical Morphologies of PLGA Scaffolds", UK JOURNAL OF PHARMACEUTICAL BIOSCIENCES, vol. 2, no. 1, 1 January 2014 (2014-01-01) , pages 1-6, XP055279536, ISSN: 2347-9442, DOI: 10.20510/ukjpb/2/i1/91124
- JIN ZHINA ET AL: "Alkylamine-effected formation of PVB-capped silver nanoparticles in alcohol solution at room temperature", MICRO AND NANO LETTERS, THE INSTITUTION OF ENGINEERING AND TECHNOLOGY, MICHAEL FARADAY HOUSE, SIX HILLS WAY, STEVENAGE, HERTS. SG1 2AY, UK, vol. 7, no. 5, 31 May 2012 (2012-05-31), pages 496-500, XP006042280, DOI: 10.1049/MNL.2012.0276
- Yeoung Uk Seo: "thermal/Photo conversion of Silver 4-Nitrobenzoate to Nitro/Amine-terminated Silver nanoparticles", , 4 February 2004 (2004-02-04), XP055279713, Retrieved from the Internet: URL:http://pubs.acs.org/doi/pdf/10.1021/jp 0364250 [retrieved on 2016-06-10]
- Schottmann: "2-Dîethylaminoethanol", , 7 March 2003 (2003-03-07), XP055279907, Retrieved from the Internet: URL:http://www.inchem.org/documents/sids/s ids/DIETHYLAMINOETHAN.pdf [retrieved on 2016-06-13]

## Description

### TECHNICAL FIELD

The present invention relates to a process for producing silver fine particles coated with a protecting layer including an alkylamine, and to a paste comprising coated silver fine particles produced by the process.

### BACKGROUND ART

In addition to having high electrical conductivity, high oxidation stability and high visible light reflectance which are specific to metal silver, silver fine particles are known to be capable of being sintered at relatively low temperatures to form silver films. With these properties, silver fine particles are used in the form of conductive inks or pastes for use as promising wiring materials in printed electronics that is a next-generation process technology for the manufacturing of electronic wires and electronic devices by simple printing/coating steps.

Further, silver ions exhibit very high bactericidal properties with respect to microorganisms such as bacteria. Thus, the use of silver fine particles having a large specific surface area is expected to make it possible to obtain high bactericidal power with a trace amount of silver. Furthermore, silver fine particles are studied for use as materials in colorants or reflectors to take advantage of the specific optical properties.

While silver fine particles may be produced by various processes, a general process is such that the surface of silver fine particles is coated with various protecting layers at the same time as the particles are formed. Namely, the particles are produced in the form of coated silver fine particles in order to prevent the aggregation of the silver fine particles and to improve properties such as dispersibility in solvents. Generally, such coated silver fine particles are produced by reducing a silver-containing compound with a reducing agent in the presence of agents such as organic molecules that will form a protecting layer on the silver particles. For example, Patent Literature 1 describes a technique in which a complex of silver nitrate with an amine is dropped to a reducing agent such as ascorbic acid and thereby the silver nitrate is reduced to produce coated silver fine particles. Patent Literature 2 describes a technique in which a silver salt such as silver nitrate is reduced by being heated in the presence of an organic protective agent and a reduction auxiliary, thereby producing silver particles coated with the organic protective agent.

These processes utilizing reduction reaction between a plurality of components including a silver-containing compound and a reducing agent have a problem in that the formation of silver particles does not necessarily take place uniformly and nonuniform silver fine particles are produced due to reasons such as minor variations in the mixing ratio of the components. In order to reduce the influence of variations in the mixing ratio and to prevent problems such as the coarsening of silver fine particles, it is effective to dissolve a silver-containing compound and a reducing agent in a large amount of a solvent with a low concentration. However, this approach is disadvantageous because of the high cost associated with the use of large amounts of solvents and also in terms of the yield of silver.

To improve these techniques, the present inventors have developed a technique in which an alkylamine is bonded to a silver-containing compound such as silver oxalate to form a complex compound, which is then pyrolyzed by heating to give coated silver fine particles (hereinafter, the process will be written as the "amine complex thermal decomposition process" or more simply as the "amine complex decomposition process") (see, for example, Patent Literature 3). In the amine complex decomposition process, the reaction used to form silver fine particles is the pyrolysis of a single amine complex into plural components. Thus, nonuniformity due to variations in conditions such as concentrations is unlikely to occur and silver fine particles having uniform properties may be obtained easily as compared to when reduction reaction takes place among a plurality of components. Further, the process does not generally entail media such as organic solvents, and silver fine particles may be obtained even in the absence of solvents.

Patent Literature 4 describes a method in which silver oxalate is reacted with a saturated aliphatic amine and oleylamine to produce a complex compound and the complex decomposed under heating so as to produce silver fine particles.

Patent Literature 5 describes a process comprising reacting a silver compound with a reducing agent comprising a hydrazine compound in the presence of a stabilizer such as an organoamine to produce silver nanoparticles.

### CITATION LIST

### Patent Literature

Patent Literature 1: Japanese Patent Application Kokai Publication No. 2009-144197
Patent Literature 2: Japanese Patent Application Kokai Publication No. 2007-39718
Patent Literature 3: Japanese Patent Application Kokai Publication No. 2010-265543
Patent Literature 4: Japanese Patent Application Publication No. 2009-270146
Patent Literature 5: European Patent Application Publication No. 1 646 095

### DISCLOSURE OF INVENTION

### Technical Problem

In the production of silver fine particles by the amine complex decomposition process, as described above, an alkylamine is bonded beforehand to a silver-containing compound such as silver oxalate to form a complex compound. In this regard, in cases where only alkylamine molecules that can form a relatively stable coating as coating molecules on coated silver fine particles to be produced, the formation of a complex compound is frequently difficult or takes a long time. It is therefore effective to use an auxiliary that facilitates the formation of a complex compound between a silver-containing compound and an alkylamine.

Patent Literature 3 describes that the combined use of an alkylamine with an alkyldiamine having higher polarity allows for quick formation of a complex compound including the alkylamine and a silver-containing compound regardless of the type of the alkylamine, and thus makes it possible to obtain satisfactory coated silver fine particles.

However, auxiliaries such as alkyldiamines used mainly to help the formation of a complex compound are incorporated into the coatings in the coated silver fine particles produced and thus will affect various properties of the coated silver fine particles. It is therefore expected that replacing such auxiliaries by other components will be desirable in some cases depending on the use applications of the coated silver fine particles.

It is therefore an object of the invention to provide a novel and non conventional process for producing coated silver fine particles by the so-called amine complex decomposition process, and to provide a paste comprising coated silver fine particles produced by the process.

### Solution to Problem

To solve the problems discussed above, the present inventors extensively studied processes for producing silver fine particles coated with a protecting layer including an alkylamine. As a result, the present inventors have found that the formation of a complex compound by mixing a silver compound capable of generating metal silver by thermal decomposition with an alkylamine is facilitated by the addition of an alcoholic compound having a solubility in water or the addition of a compound having a carbon-heteroatom multiple bond in the molecule and/or a compound having a heteroatom-heteroatom multiple bond in the molecule, and the complex compound can be formed in a quick and efficient manner.

A process for producing coated silver fine particles according to the present invention includes:
a first step of forming a complex compound including a silver compound and an alkylamine by mixing
   (1) a silver compound capable of generating metal silver by thermal decomposition,
   (2) an alkylamine represented as an alkylamine RNH₂ having a primary amino group in the amine moiety or alkylamines RR'NH having a secondary amino group in the amine moiety, wherein R and R' each independently indicate a hydrocarbon group, and
   (3) at least one alcoholic compound having a solubility in water and has a boiling point of 70°C or more and/or a compound having at least one of a carbon-heteroatom multiple bond and a heteroatom-heteroatom multiple bond in the molecule, and
a second step of generating silver fine particles coated with a protecting layer including the alkylamine by thermal decomposition of the complex compound,
wherein the compound having a carbon-heteroatom bond or a heteroatom-heteroatom multiple bond in the molecule is selected from the group consisting of ketone compounds, aldehyde compounds, ester compounds, amide compounds, carbamide compounds, imide compounds, oxime compounds, nitrile compounds, isonitrile compounds, isocyanates compounds. cyanate compounds, azo compounds, nitro compounds, nitroso compounds and azides; and
wherein the amount of alcoholic compound and/or a compound having at least one of a carbon-heteroatom multiple bond and a heteroatom-heteroatom multiple bond is 5 mol% to 500 mol% relative to the alkylamine.

The heteroatom is preferably an oxygen atom or a nitrogen atom, and the compound preferably includes one or both of these atoms. More preferably, the number of carbon atoms present in the compound is 14 or less.

### Advantageous Effects of Invention

According to the process of the invention, the formation of a complex compound which includes a silver compound capable of generating metal silver by thermal decomposition and an alkylamine is facilitated and thereby silver fine particles coated with a protecting layer including the alkylamine may be produced efficiently. Thus, the inventive process can contribute to the reduction of production cost. Further, the process of the invention allows one to select and optimize the type of the alkylamine used as the protecting layer in accordance with the application of the coated silver fine particles, thus achieving great utility in practical use. When, for example, the particles are used in inks, the dispersibility in solvents may be increased by adding a long chain alkylamine or a fatty acid. To enhance sintering properties at low temperatures, the content of a medium or short chain alkylamine may be increased.

### BRIEF DESCRIPTION OF DRAWINGS

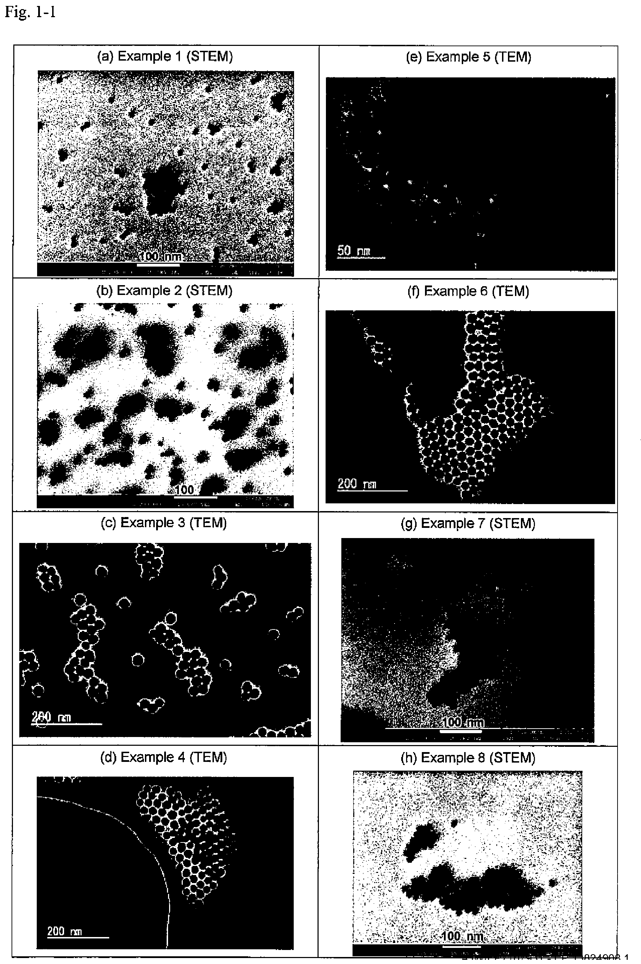

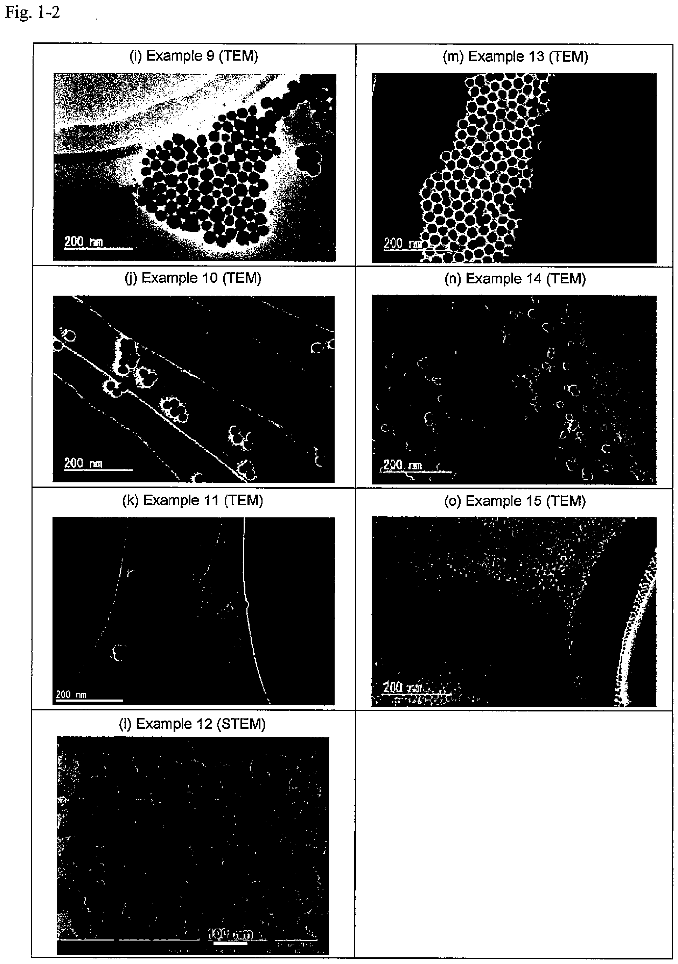

Fig. 1-1 is a set of scanning transmission electron microscope (STEM) images and transmission electron microscope (TEM) images of silver fine particles obtained in Examples 1 to 8.
Fig. 1-2 is a set of scanning transmission electron microscope (STEM) images and transmission electron microscope (TEM) images of silver fine particles obtained in Examples 9 to 15.

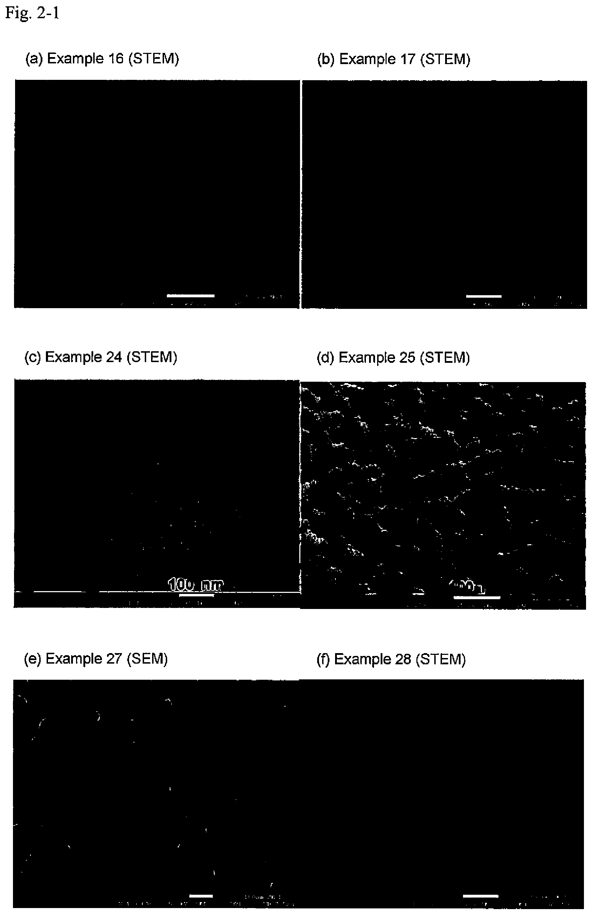

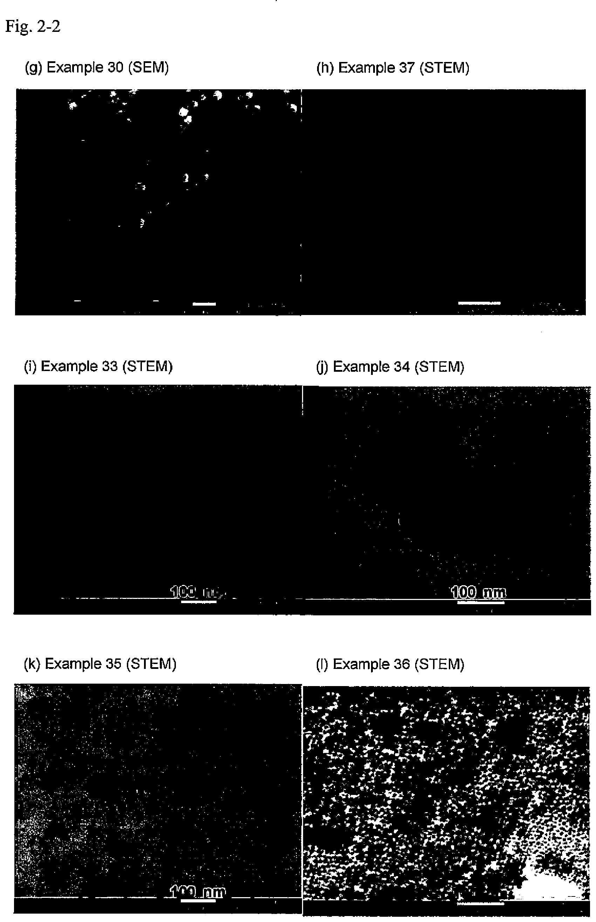

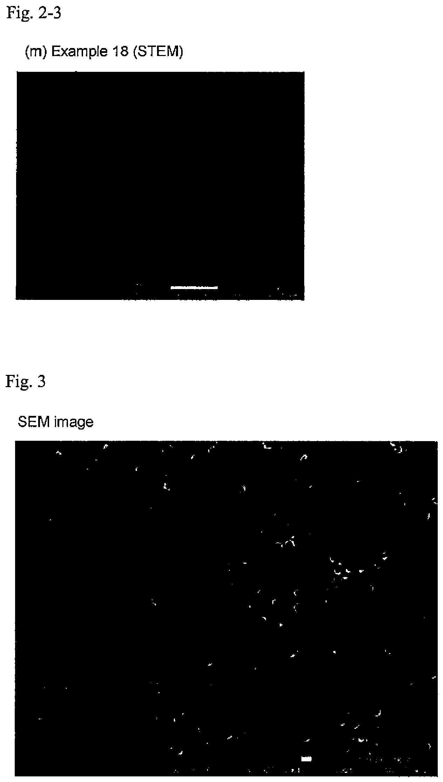

Fig. 2-1 is a set of scanning transmission electron microscope (STEM) images and scanning electron microscope (SEM) images of typical coated silver fine particles produced by processes of the invention, wherein (a), (b), (c), (d), (e) and (f) are STEM images or SEM images of coated silver fine particles produced by processes in Examples 16, 17, 24, 25, 27 and 28, respectively.
Fig. 2-2 is a set of scanning transmission electron microscope (STEM) images and scanning electron microscope (SEM) images of typical coated silver fine particles produced by processes of the invention, wherein (g), (h), (i), (j), (k) and (1) are STEM images or SEM images of coated silver fine particles produced by processes in Examples 30, 37, 33, 34, 35 and 36, respectively.
Fig. 2-3 is a scanning transmission electron microscope (STEM) image (m) of typical coated silver fine particles produced by a process in Example 18 of the invention.
Fig. 3 is an electron microscope (SEM) image illustrating a surface structure of a film after the sintering of the coated silver fine particles obtained by the process in Example 27.

### BEST MODE FOR CARRYING OUT INVENTION

Hereinbelow, processes for producing coated silver fine particles of the invention and a paste comprising coated silver fine particles produced by the inventive process will be described. As described in Patent Literature 3, a process is known in which a silver-containing complex compound mainly composed of a silver compound such as silver oxalate and an alkylamine is heated under specific conditions so as to cause chemical changes, for example, to decompose the silver compound such as oxalate ion present in the complex compound and thereby atomic silver is generated and aggregated in the presence of the alkylamine to form silver fine particles protected with a protecting layer of the alkylamine. In such an amine complex decomposition process, the atomic metal silver is generated by the decomposition reaction of a single kind of molecules, namely, the silver amine complex. Consequently, the atomic metal silver may be uniformly generated in the reaction system. Specifically, the reaction may be prevented from being nonuniform due to variations in the composition of components participating in the reaction as compared to when silver atoms are generated by a reaction of a plurality of components. In particular, such a process is advantageous when a large amount of coated silver fine particles is produced on an industrial scale.

In the amine complex decomposition process, alkylamine molecules are coordinately bonded to the silver atoms generated. The alkylamine molecules coordinated to the silver atoms are assumed to control the movement of the silver atoms during aggregation. Because of this function, problems such as excessive aggregation are unlikely to occur even when the particles are produced in an environment having a high concentration of silver atoms, and the obtainable silver fine particles attain a narrow particle size distribution. Further, a large number of alkylamine molecules are coordinately bonded with a relatively weak force to the surface of the silver fine particles produced. Specifically, they form a dense protecting layer on the surface of the silver fine particles, and consequently the coated silver fine particles have a clean surface and exhibit excellent storage stability. Furthermore, the alkylamine molecules forming such a coating may be readily detached by treatment such as heating, and thus the silver fine particles may be sintered at a very low temperature.

As described above, the silver amine complex decomposition process is an advantageous universal process for the production of coated silver particles which are fine and can be sintered at a low temperature. The production of silver fine particles by the amine complex decomposition process involves a reaction in which raw materials such as a silver compound and an alkylamine are reacted to form a complex compound. It is assumed that this reaction is driven by the change in free energy during the formation of a coordination bond of a ligand such as the alkylamine to the silver atom in the silver compound. One issue, however, is that given that the change in free energy associated with the formation of such a coordination bond is not necessarily large, the formation of the complex compound does not necessarily proceed smoothly. Further, the silver compound that is used as the source of silver atoms is frequently solid and therefore the reaction which affords products such as the complex compound of the silver compound with the alkylamine occurs only at the solid-liquid interface between these compounds. Due to this fact, prolonged mixing treatment is generally required to complete the weakly driven reaction affording products such as the above complex compound. Further, products such as the complex compound between the silver compound and the alkylamine are not formed as expected depending on the selection of these compounds.

Patent Literature 3 disclosed by the present inventor addresses this problem. Specifically, it has been shown that a complex compound may be synthesized without solvents at a low temperature in a short time by using a medium or short chain alkylmonoamine having a boiling point of 100°C to 250°C in combination with a medium or short chain alkyldiamine having a higher polarity, and this complex compound may be treated to give coated silver fine particles which can be sintered at a low temperature. Such coated silver fine particles produced by this process may be sintered at a very low temperature for a silver-sintering temperature, specifically, at near room temperature. Further, the particles may be dispersed in an organic solvent with a high concentration. These properties make the particles highly useful in various applications. For example, the particles may be dispersed in an appropriate dispersion medium to give an ink which can form good conductive films even on poorly heat resistant substrates such as plastic substrates.

Studies by the present inventor have revealed that when a solid silver compound and an alkylamine are mixed with each other to form composites such as a complex compound, the formation of the silver compound-amine complex compound proceeds smoothly in the presence of an alcoholic compound having a certain extent of polarity. This is probably because the alcoholic compound having a certain extent of polarity promotes and helps the complex-forming reaction between the silver compound and the alkylamine.

In the invention, the term alcoholic compound refers to a hydrocarbon whose at least one hydrogen atom is replaced by a hydroxyl group (-OH). The positions and the number of hydrogen atoms that are replaced are not limited. The present invention is characterized in that such an alcoholic compound having a certain extent of polarity is used.

While it is generally difficult to quantitatively determine the strength of the polarity of alcoholic compounds, the strength of the polarity of various alcoholic compounds may be estimated semi-quantitatively based on the solubility in water (H₂O) that is a polar solvent. Specifically, alcoholic compounds tend to exhibit a higher solubility in water with increasing polarity and to show a lower solubility with decreasing polarity.

In the invention, extensive studies of the relationship between the water solubility of various alcoholic compounds and their effect in the promotion of the formation of a silver compound-alkylamine complex compound have shown that alcoholic compounds having a significant solubility in water provide a certain effect in promoting the formation of a silver compound-alkylamine complex compound. In contrast, it has been shown that alcoholic compounds having no solubility in water do not have a significant effect in promoting the formation of such a complex compound.

In detail, octanol known to have a water solubility of about 0.3 g/L (20°C) has been shown to promote the formation of a complex between a silver compound and an alkylamine. Further, a tendency has been observed in which the time required for the formation of a silver compound-alkylamine complex compound is significantly reduced by the use of an alcoholic compound having a water solubility of about 10 g/L or more. It has been also observed that the time required for the formation of such a complex compound tends to be markedly reduced with an alcoholic compound having a solubility of 30 g/L or more. Alcoholic compounds having a water solubility of at least 70 to 80 g/L have shown another tendency in which the time required for the formation of a silver compound-alkylamine complex compound is determined by the respective structures such as the number of OH groups present in the compounds regardless of the magnitude of the solubility. Here, the water solubility generally refers to the maximum mass in g of the solute dissolved in 1 L of water at room temperature. Here, the term room temperature indicates 20°C to 25°C, and preferably 20°C.

In the step of thermal decomposition of the complex compounds synthesized in the studies, those complex compounds synthesized in the presence of an alcoholic compound showed a readiness to be fully decomposed more quickly than those complex compounds produced without any alcoholic compounds. Silver compounds in the form of complex compounds with alkylamines generally tend to be pyrolyzed at a temperature that is equal to or lower than their usual pyrolysis temperatures. It is considered that this tendency is because the bonding of alkylamines, for example, the coordination bonding of alkylamines to the silver compounds destabilizes the structures of the silver compounds and consequently the compounds are activated. From this viewpoint, it is assumed that the presence of alcoholic compounds allowed for the formation of good complex compounds both macroscopically and microscopically.

On the other hand, variations in the types of alcoholic compounds present during the formation of silver compound-alkylamine complex compounds showed a tendency to have an influence in the step of thermally decomposing the complex compounds. Specifically, the thermal decomposition reaction of the complex compound is preferably performed at as low a temperature as possible, usually about 70 to 150°C, in order to prevent the vaporization of materials such as the alkylamine used. However, alcoholic compounds with a relatively low boiling point are prone to be vaporized markedly even at such temperatures and consequently the reaction which affords coated silver fine particles tends to be destabilized. This is probably ascribed to such phenomena as the latent heat absorption by the vaporization of the alcoholic compound and the partial dissociation of the complex compound to a silver compound. These phenomena have a risk of causing instability particularly during mass production on an industrial scale. The above tendencies are marked in particular in the case of such alcohols as ethanol. It is therefore preferable that unnecessary alcoholic compounds be removed beforehand as required after the formation of complex compounds, or the complex compounds be heat decomposed after such alcohols are replaced by appropriate components such as other alcoholic compounds or alkylamines.

On the other hand, alcoholic compounds having a relatively high boiling point are advantageous in terms of stable formation of coated silver fine particles because of their capability of staying stable in the reaction system even during the step of thermal decomposition of complex compounds. However, high-boiling alkyl alcohols having a single OH group generally tend to have a low water solubility because of their large molecular weights and hence such alcoholic compounds tend to exhibit a low effect in the promotion of the formation of complex compounds. That is, the use of such alcoholic compounds tends to encounter a tradeoff.

In light of the above facts, some of the alcoholic compounds that are particularly suited for use in the invention are glycols having two OH groups in the molecule and glycerols having three OH groups.

In the invention, it has been also found that the particle size of the obtainable coated silver fine particles may be changed by altering the type of the alcoholic compound present during the formation of a silver compound-alkylamine complex compound. Although the reasons are not clear as to why the particle size of the coated silver fine particles is varied by the selection of the type of the alcoholic compound, it is assumed that depending on the types of the alcoholic compounds, the alkylamine exhibits various levels of its function to prevent coarsening during the process in which silver atoms generated by the thermal decomposition of the complex compound are aggregated.

As will be demonstrated by the results in Examples later, it has been found that properties such as conductivity obtained after the sintering of the coated silver fine particles may be changed by altering conditions such as the type of the alcoholic compound used in the invention. This fact probably indicates that changing the types of the alcoholic compounds not only results in a variation in the particle size of the coated silver fine particles but also gives rise to a change in the structure of the coating as a result of the alcoholic compound being introduced into the coating.

Further studies by the present inventors have shown that when a solid silver compound and an alkylamine are mixed with each other to form composites such as a complex compound, the reaction which affords the silver compound-alkylamine complex compound is allowed to proceed smoothly in the presence of compound molecules having a multiple bond between a carbon atom and a heteroatom such as oxygen, nitrogen, sulfur or phosphorus, or a multiple bond between heteroatoms in the molecule.

The reasons are not fully clear as to why the synthesis of such a complex compound is promoted by the above compound. It is, however, known that a heteroatom such as oxygen or nitrogen which is bonded to a carbon atom exhibits a higher polarity when the bond is a multiple bond than when the bond is a single bond and consequently the unshared electron pair is exposed. This probably increases the tendency of the compound to form a coordination bond to the silver atom in the silver compound. Similarly in the case of multiple bonds between the same or different heteroatoms, it is assumed that the unshared electron pairs on the respective atoms are activated and consequently the compounds exhibit a higher tendency to form a coordination bond to the silver atom in the silver compound, with the result that the solid silver compound is broken and the formation of a silver compound-alkylamine complex compound is promoted.

Those complex compounds which are synthesized in the presence of the compound molecules having a multiple bond show a readiness to be fully decomposed more quickly in the subsequent thermal decomposition step than those complex compounds formed by simply mixing a silver compound with an alkylamine alone. Silver compounds in the form of complex compounds with alkylamines generally tend to be pyrolyzed at a temperature that is equal to or lower than their usual pyrolysis temperatures. It is considered that this tendency is because the bonding of alkylamines, for example, the coordination bonding of alkylamines to the silver compounds destabilizes the structures of the silver compounds and consequently the compounds are activated. From this viewpoint, it is assumed that the presence of compound molecules having a multiple bond allowed for the formation of good complex compounds both macroscopically and microscopically.

It has been further shown that depending on the types of the compound molecules added during the formation of the complex compound, the coated silver fine particles produced in accordance with the present invention exhibit marked differences in properties such as the mean particle size of the silver fine particles, the dispersibility in solvents and the residual resistance after sintering. It is therefore assumed that the compound molecules used as additive components are incorporated into the resultant complex compound and hence into the coating in the coated silver fine particles, thus affecting the process of the formation of the coated silver fine particles and imparting various properties to the coated silver fine particles.

There will be described in detail hereinbelow a process for producing coated silver fine particles according to the invention, and a paste comprising coated silver fine particles produced by the production process.

### (Silver compounds capable of generating metal silver by thermal decomposition)

Of the silver-containing compounds used as the raw materials for silver in the production of coated silver fine particles, those silver compounds that are easily decomposed by heating to generate atomic silver are preferable. Examples of such silver compounds include silver carboxylates in which silver atoms are bonded to carboxylic acids such as formic acid, acetic acid, oxalic acid, malonic acid, benzoic acid and phthalic acid, as well as silver chloride, silver nitrate and silver carbonate. Of these, silver oxalate is preferably used for reasons such as that this carboxylate is easily decomposed to generate metal silver and produces negligible amounts of impurities other than silver. Silver oxalate is advantageous in that the silver content is high, the carboxylate is easily decomposed at a low temperature that is usually 200°C or below, and impurities will not remain in the metal silver because the oxalate ions are removed as carbon dioxide during the decomposition. For example, commercial silver oxalate may be used in the process of the invention. It is also possible to use silver compounds derived from silver oxalate by replacing oxalate ions with 20 mol% or less of at least one of carbonate ions, nitrate ions and oxide ions. In particular, thermal stability may be increased by replacing 20 mol% of less of the oxalate ions in silver oxalate with carbonate ions. However, replacing more than 20 mol% of the oxalate ions often results in a complex compound that is difficult to decompose by heating.

### (Alkylamines)

Preferred examples of the amines used in the production of coated silver fine particles by the amine complex decomposition process include alkylmonoamines and alkyldiamines in which an amino group or groups is or are bonded to a portion of an alkyl group. In the specification, the term alkylamines refers to any of alkylmonoamines in which one amino group is bonded to an alkyl group, and alkyldiamines in which two amino groups are bonded to an alkyl group. These two types will be distinguished as alkylmonoamines and alkyldiamines as required.

In the production process of the invention, alkylmonoamines are mainly used as the alkylamines, and alkyldiamines may be appropriately mixed in accordance with needs such as the desired properties of coated silver fine particles that are produced.

In order for the alkylamines used in the process of the invention to form a coordination bond to the surface of silver fine particles via the amino group, it is preferable that the amines be alkylamines RNH₂ having a primary amino group in the amine moiety or alkylamines RR'NH having a secondary amino group in the amine moiety. In the specification, R and R' each independently indicate a hydrocarbon group. As a result of the amino group being primary or secondary, the amine moiety may form a complex compound with the metal compound by forming a coordination bond to the metal atom via the unshared electron pair of the nitrogen atom in the amino group, thereby forming a coating of the alkylamine on the metal fine particles. In contrast, a tertiary amino group is rather undesirable due to the fact that the free space around the nitrogen atom in the amino group is generally small and hence it is difficult for the amine to form a coordination bond to the metal atom. However, tertiary amines may be used appropriately in accordance with needs such as the application of coated silver fine particles produced by the process of the invention.

The amines such as alkylamines generally show a tendency in which the vapor pressure is decreased and the boiling point is increased with increasing molecular weight and increasing chain length of the alkyl group. On the other hand, alkylamines in which the alkyl groups have a low molecular weight and a short chain tend to exhibit a high vapor pressure and a high polarity. Alkyldiamines having two amino groups in the molecule tend to have a higher polarity than alkylmonoamines having a single amino group in the molecule. While the process of the invention may involve any of these alkylamines, the alkylamines are defined as short chain amines, medium chain amines or long chain amines when the number of carbon atoms present in the alkyl group is 2 to 5, 6 to 12, or 13 or more, respectively. Characteristics of these amines will be described below.

The long chain or medium chain alkylmonoamines generally have a low vapor pressure and are difficult to vaporize. In addition, these alkylamines exhibit high affinity for organic solvents. Thus, the use of such alkylmonoamines or amine mixtures containing such amine components results in coated silver fine particles which contain the prescribed proportions of the long chain or medium chain alkylmonoamines in the coating. Therefore, storage properties and dispersibility in non-polar organic solvents may be enhanced. It is therefore desirable that a long chain or medium chain alkylmonoamine be contained in the coating of coated silver fine particles when, for example, the coated silver fine particles are dispersed in appropriate organic solvents to give inks or the like.

Examples of the long chain or medium chain alkylmonoamines include dipropylamine (107°C), dibutylamine (159°C), hexylamine (131°C), cyclohexylamine (134°C), heptylamine (155°C), octylamine (176°C), nonylamine (201°C), decylamine (217°C), dodecylamine (248°C), hexadecylamine (330°C), oleylamine (349°C) and octadecylamine (232°C (32 mmHg)). These alkylmonoamines are practical because of their high availability. However, the long chain or medium chain alkylmonoamines are not limited thereto, and other such amines having 6 or more carbon atoms may be used appropriately in accordance with the purpose. In the invention, even amines which are solid at room temperature may be used as long as such amines may be liquefied by being mixed with other components such as additive components described later.

On the other hand, the rate of the formation of a complex compound between an alkylmonoamine and a silver compound tends to be decreased as the length of the alkyl chain of the alkylmonoamine is increased. It is generally observed that the formation of a complex compound does not complete even after prolonged mixing when the alkylmonoamine used has a long chain with 18 or so carbon atoms. In the case of medium chain alkylmonoamines, a complex compound can be generally formed by mixing the amine with the silver compound for an extended period of time.

In contrast, alkyldiamines and short chain alkylmonoamines having 5 or less carbon atoms may form complex compounds with the silver compounds relatively easily. Thus, the production of coated silver fine particles by the amine complex decomposition process may use alkylamines based on an alkyldiamine or a short chain alkylmonoamine having 5 or less carbon atoms.

Further, an alkyldiamine or a short chain alkylmonoamine having 5 or less carbon atoms may be mixed in an appropriate proportion with a long chain or medium chain alkylmonoamine. In such a case, the obtainable coated silver fine particles attain advantages of both types of amines. Specifically, the use of a mixture containing these different types of alkylamines in appropriate proportions makes it possible to form a silver compound-alkylamine complex compound in a favorable manner and also to produce coated silver fine particles which exhibit excellent storage stability and which may be dispersed in a non-polar organic solvent.

Examples of the short chain alkylmonoamines include amylamine (boiling point 104°C), butylamine (78°C), diethylamine (55°C), propylamine (48°C), isopropylamine (34°C), ethylamine (17°C) and dimethylamine (7°C). These are easily available in industry and are thus desirably used.

In light of the pyrolysis temperature of the complex compounds, the boiling point of the alkyldiamines may be appropriately 100°C or above. In consideration of low-temperature sintering properties of the obtainable coated silver fine particles, the boiling point of the alkyldiamines may be appropriately 250°C or less. Examples of such amines include, but are not limited to, ethylenediamine (118°C), N,N-dimethylethylenediamine (105°C), N,N'-dimethylethylenediamine (119°C), N,N-diethylethylenediamine (146°C), N,N'-diethylethylenediamine (153°C), 1,3-propanediamine (140°C), 2,2-dimethyl-1,3-propanediamine (153°C), N,N-dimethyl-1,3-diaminopropane (136°C), N,N'-dimethyl-1,3-diaminopropane (145°C), N,N-diethyl-1,3-diaminopropane (171°C), 1,4-diaminobutane (159°C), 1,5-diamino-2-methylpentane (193°C), 1,6-diaminohexane (204°C), N,N'-dimethyl-1,6-diaminohexane (228°C), 1,7-diaminoheptane (224°C) and 1,8-diaminooctane (225°C).

Coated silver fine particles may be produced by the amine complex decomposition process using various types of alkylamines. In such a case, an amine such as an alkylamine different from the alkylamine that has been mixed with a silver compound to form a complex compound or that is present in the form of a coating on silver fine particles may be mixed with the complex compound or the coated silver fine particles to replace the alkylamine present in the complex compound or the coated silver fine particles. This technique is effective when silver fine particles are to be coated with an alkylamine which is difficult to use in the synthesis, for example, an alkylamine which is difficult to form a complex compound.

### (Alcoholic compounds)

The invention is characterized in that the formation of a complex compound from materials such as a silver compound and an alkylamine takes place in the presence of an alcoholic compound having at least a certain extent of polarity. The alcoholic compounds used in this reaction are desirably such that a solubility in water (H₂O) is typically observed at room temperature. The alcoholic compounds showing a solubility in water have a certain extent of polarity, and the use of such alcoholic compounds makes it possible to promote the formation of a complex compound from materials such as a silver compound and an alkylamine. The specific functions of the alcoholic compounds in the reaction are not clear. However, it is probable that while a solid silver compound does not allow a ligand, in particular, a long chain or medium chain alkylamine to be coordinated smoothly to the silver atom because the silver compound, specifically, the silver-containing molecules are aggregated in the form of crystals or the like, the alcoholic compound with a high polarity breaks the structures such as crystals of the silver compound and thereby allows a ligand such as an alkylamine to be coordinated to the metal efficiently.

Further, the alcoholic compound used in the reaction is contained in the resultant complex compound and even to the coating of coated silver fine particles obtained by thermal decomposition of the complex compound. It is therefore possible to add various functions to the obtainable coated silver fine particles by appropriately selecting the alcoholic compounds used in the invention.

To make use of the above characteristics of the specific alcoholic compounds, a preferred embodiment of the invention is such that coated silver fine particles are produced mainly using a long chain or medium chain alkylamine while the formation of a complex compound is assisted or promoted by the action of the alcoholic compound. Further, various alcoholic compounds may be used even in the case where the amine is a short chain alkylamine or an alkyldiamine. In such a case, the functions of the alcoholic compounds are to assist the formation of a complex compound and also to impart desired characteristics to the obtainable coated silver fine particles.

Examples of the alcoholic compounds showing a solubility in water include linear alkyl alcohols having a single OH group, specifically, such alcohols with 1 to 8 carbon atoms ranging from methanol to octanol. On the other hand, alcoholic compounds having 9 or more carbon atoms are not substantially dissolved in water and thus fail to promote the formation of a complex compound when used in the formation of a complex compound. Alcohols other than alkyl alcohols are also usable, with examples including phenols and compounds derived from ethers by replacing a hydrogen atom in an appropriate hydrocarbon moiety in the molecule with an OH group.

The alcoholic compounds exhibit a higher polarity with increasing number of OH groups present in the molecule. In the invention, polyhydric alcohols such as glycols having two OH groups, glycerols having three OH groups, and pentaerythritols having four OH groups are preferably used.

Examples of such alcoholic compounds include ethanol, propanol, butanol, pentanol, hexanol, heptanol, octanol, allyl alcohol, benzyl alcohol, pinacol, propylene glycol, menthol, catechol, hydroquinone, salicyl alcohol, pentaerythritol, sucrose, glucose, xylitol, methoxyethanol, triethylene glycol monomethyl ether, pentaerythritol, and polyethylene glycols including ethylene glycol, triethylene glycol, tetraethylene glycol and pentaethylene glycol.

In accordance with the applications of the obtainable coated silver fine particles, sulfur-containing alcoholic compounds may be used, with examples including 2,2'-thiodiethanol, 3-thiopheneethanol, 2-thiopheneethanol, 3-thiophenemethanol, 2-thiophenemethanol, α-thioglycerol and 2-(methylthio)ethanol. Further, phosphorus-containing alcoholic compounds may be used, with examples including dimethyl(hydroxymethyl) phosphonate and dimethyl(2-hydroxyethyl) phosphonate. Furthermore, silicon-containing alcoholic compounds may be used, with examples including 2-(trimethylsilyl)ethanol, 2-(trimethylsilyl)-1-propanol and triethylsilanol.

Part of the alcoholic compound used in the formation of a complex compound is incorporated into the complex compound or the reaction medium used in the thermal decomposition of the complex compound. When the alcoholic compound used has a high vapor pressure, the alcoholic compound is vaporized and detached during the production of coated silver fine particles by the heating of the complex compound so as to destabilize the process of the formation of the coated silver fine particles and to decrease the yield of silver atoms recovered as the coated silver fine particles.

The formation of coated silver fine particles by the thermal decomposition of a complex compound is usually performed at a temperature in the range of about 70 to 150°C. Thus, the alcoholic compound used in the invention preferably has a low vapor pressure in the above temperature range. In particular, the vapor pressure of the alcoholic compound tends to have a large influence on the formation of coated silver fine particles at atmospheric pressure. Specifically, the formation of coated silver fine particles in the presence of a low-boiling alcohol such as methanol tends to result in variations in characteristics between batches or a decrease in the silver yield. Thus, the alcoholic compounds used in the invention have a boiling point of 70°C or more, and more preferably have a boiling point of 80°C or more.

To suppress the vaporization of the alcoholic compound during the reaction for forming a complex compound, a plurality of alcoholic compounds may be used as a mixture. In this manner, the vapor pressure of the alcoholic compounds may be effectively lowered. Further, the vapor pressure may be effectively reduced by adding appropriate amounts of substances such as water, ketones and aldehydes which show a solubility with respect to the alcoholic compound used.

The amount of the alcoholic compound used in the process of the invention is about 5 mol% to 500 mol% relative to the alkylamine used in the formation of a complex compound. If the molar ratio of the alcoholic compound used is not more than 5 mol% relative to the alkylamine, the alcoholic compound tends to exhibit an insufficient effect in promoting the formation of a complex compound. If, on the other hand, the molar ratio of the alcoholic compound used is not less than 500 mol% relative to the alkylamine, the activity of the alkylamine tends to be decreased and the formation of a complex compound tends to be inhibited.

When, in particular, the alcoholic compound is used in an amount of about 10 mol% to 300 mol% relative to the alkylamine, the formation of a complex compound is favorably promoted to afford a good complex compound. With an increase in the proportion of the alcoholic compound within the above range, the time required for the formation of a complex compound is generally reduced and, because the obtainable complex compound contains a higher proportion of the alcoholic compound, the coated silver fine particles resulting from the thermal decomposition of the complex compound have larger particle sizes and also exhibit higher dispersibility with respect to polar solvents. On the other hand, a decrease in the proportion of the alcoholic compound leads to a decrease in the amount of the alcoholic compound contained in the complex compound or in the coating of coated silver fine particles. Consequently, the obtainable coated silver fine particles tend to have small sizes and a dense coating.

Most typically, the amount of the alcoholic compound is preferably about 25 mol% to 100 mol% relative to the alkylamine. However, the specific type and amount of the alcoholic compound are preferably selected and controlled appropriately in accordance with purposes such as the desired properties of coated silver fine particles that are produced.

In the invention, the alcoholic compound may be used in the formation of a silver compound-alkylamine complex compound in such a manner that the silver compound is added to a mixture of the alkylamine and the alcoholic compound, such that the alcoholic compound is mixed together with the silver compound to cause a change such as the breakage of the silver compound and thereafter the alkylamine is added to form a complex compound, or such that the alcoholic compound is added to a mixture of the silver compound and the alkylamine to form a complex compound.

For purposes such as increasing the yield of coated silver fine particles and enhancing the uniformity of the particles, the alcoholic compound may be added to a mixture which contains a complex compound being formed by the mixing of a silver compound and an alkylamine and thereby the silver compound may be treated during the occurrence of the complex-forming reaction.

### (Additive components used in complex formation)

In the invention, it has been found that the formation of a silver compound-alkylamine complex compound is allowed to take place smoothly in the presence of a compound having a carbon-heteroatom multiple bond or a heteroatom-heteroatom multiple bond in the molecule, in addition to or in place of the alcoholic compound. In the invention, specifically, it has been found that while a solid silver compound does not allow a ligand, in particular, a long chain or medium chain alkylamine to be coordinated smoothly to the silver atom because the silver compound, namely, the silver-containing molecules and ions are aggregated in the form of crystals or the like, the above compound with a specific multiple bond in the form of a mixture with the alkylamine allows the ligand such as the alkylamine to be coordinately bonded to the silver compound efficiently to form a complex compound. This effect is probably ascribed to a mechanism in which the above compound efficiently breaks the structures such as crystals of the silver compound and consequently the ligand such as the alkylamine can have more frequent contacts with the silver compound.

This compound used in the invention has a carbon-heteroatom multiple bond or a heteroatom-heteroatom multiple bond in the molecule. In such a compound, it is known that the distribution of electrons which are involved in the bonds belonging to the heteroatom forming the multiple bond is unbalanced by the influence of the multiple bond, and consequently the unshared electron pair on the heteroatom tends to be exposed and to exhibit higher activity in reactions which take place via the unshared electron pair. In the invention, the detailed reasons are not clear as to why the presence of the above compound having a specific multiple bond promotes the formation of a silver compound-alkylamine complex compound. However, it is assumed that the promoted formation of a complex compound is related to the fact that the heteroatom contained in the compound has such an active unshared electron pair.

Specific examples of the above compounds used in the invention include ketone compounds, aldehyde compounds, ester compounds, amide compounds, carbamide compounds, imide compounds and isocyanate compounds having a carbon-oxygen double bond, oxime compounds, Schiff base compounds and nitrile compounds having a carbon-nitrogen multiple bond, nitro compounds and nitroso compounds having an oxygen-nitrogen multiple bond, and azo compounds, diazo compounds and azides having a nitrogen-nitrogen multiple bond. The formation of a silver compound-alkylamine complex compound may be promoted also by compounds in which other types of heteroatoms such as sulfur and phosphorus are involved in the multiple bonds. However, adverse effects tend to be caused by the remaining of such sulfur atoms or phosphorus atoms in the silver fine particles produced for use in the fabrication of, for example, conductive wires. It is therefore desirable that the use of such heteroatoms be considered in accordance with purposes such as the application of silver fine particles that are produced.

The compounds used in the invention tend to decrease the function to promote the formation of a complex compound with increasing number of carbon atoms present in the compounds or with increasing number of carbon atoms present in functional groups in the compounds. Depending on the basic structures of the compounds, the number of carbon atoms has various influences on the effect of promoting the formation of a complex compound. For example, compounds containing one multiple bond generally tend to decrease their effect in promoting the complex compound formation when the number of carbon atoms present in the compounds exceeds 14. On the other hand, it is generally observed that the effect in promoting the formation of a complex compound is markedly high when the number of carbon atoms present in the compounds is 7 or less.

To make use of such characteristics, a preferred embodiment of the invention is such that coated silver fine particles are produced mainly using a long chain or medium chain alkylamine while the formation of a complex compound is assisted or promoted by the action of the above compound.

Further, the compound with a specific multiple bond used in the invention is introduced into the resultant complex compound and even to the coating of coated silver fine particles obtained by thermal decomposition of the complex compound. It is therefore possible to add various functions to the obtainable coated silver fine particles by appropriate selection from various such compounds in the invention. Thus, the compounds may be used even in the case where the amine is a short chain alkylamine or an alkyldiamine in order to assist the formation of a complex compound and also to impart desired characteristics to the obtainable coated silver fine particles.

As the aforementioned compounds, ketone compounds are compounds for use in the formation of a silver compound-alkylamine complex compound in the invention.

The ketone compounds may be represented by Formula (I):

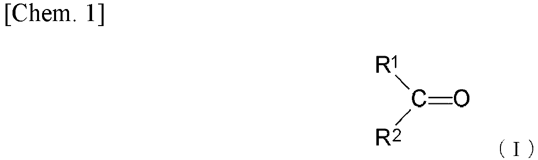

In the formula, R¹ and R² may be each an alkyl group, an alkenyl group, an alkynyl group, an alkoxy group, an alkylamino group, a hydroxylamino group or an optionally substituted aryl group (an aromatic monovalent mono- or polycarbocyclic group, preferably a phenyl group or a naphthyl group). R¹ and R² may be linked to each other to form a ring. In particular, the alkyl groups in the invention are branched or linear, saturated aliphatic hydrocarbon groups having 1 to 10 carbon atoms (C₁₋₁₀), and preferably 1 to 6 carbon atoms (C₁₋₆), and are preferably selected from such groups as methyl, ethyl, n-propyl, isopropyl, n-butyl, s-butyl, isobutyl, t-butyl, n-pentyl, 3-methylbutyl, n-hexyl and 2-ethylbutyl. In some cases, the alkyl groups may be partially substituted with halogens.

The alkenyl groups and the alkynyl groups in the invention are suitably unsubstituted or substituted hydrocarbon chain groups with 2 to 10 carbon atoms (C₂₋₁₀), and preferably 2 to 6 carbon atoms (C₂₋₆) having a single carbon-carbon double bond or triple bond as the unsaturated bond. Examples thereof include vinyl, ethynyl, 1-propenyl, 2-propenyl, 1-propynyl, 2-propynyl, 2-butenyl (crotyl) and 2-butynyl. For other substituents such as hydrocarbon chain groups having two or more unsaturated bonds (double bonds or triple bonds), alkoxy groups and alkylamino groups, those lower groups having approximately 6 or less carbon atoms are preferably used.

Non-limiting examples of such ketone compounds include aliphatic ketones such as acetone, methyl ethyl ketone, acetylacetone, 2-butanone, 3-pentanone, 4-heptanone, 4-methyl-3-penten-2-one (mesityl oxide), 4-methyl-2-pentanone, diacetyl, pinacolin, 2,4-dimethylpentanone, 2,6-dimethyl-3-heptanone, isoamyl methyl ketone, 3-methyl-2-butanone, 5-methyl--heptanone, 4-methyl-2-pentanone, ethynyl isopropyl ketone and 2-octanone, alicyclic ketones such as cyclopentanone, cyclohexanone, 2-cyclohexenone, isophorone and dicyclohexyl ketone, and aromatic ketones such as acetophenone, benzophenone, 4-phenyl-2-butanone, isobutyrophenone, benzalacetone and propiophenone.

Examples of the ketone compounds further include oxygen-containing keto acid compounds such as methyl acetoacetate, ethyl acetoacetate, dimethyl acetyl succinate, α-acetyl-γ-butyrolactone, acetoacetic acid, methyl pyruvate, pyruvic acid, N,N-dimethylacetoacetamide, acetoacetanilide and N-acetoacetylmorpholine.

Another of the compounds used in the formation of a complex compound in the invention is aldehyde compounds of Formula (II) in which a single hydrogen atom is bonded to the carbonyl carbon.
Formula (II):

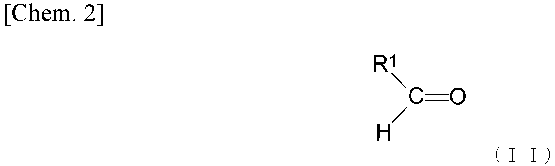

Here, R¹ may be any of the groups defined above, or may be a hydrogen atom. Non-limiting examples of the aldehyde compounds suited for use in the inventive process include propionaldehyde, n-butyraldehyde, isobutyraldehyde, n-pentylaldehyde, 2-methylbutyraldehyde, n-hexylaldehyde, 2-methylpentanal, n-heptylaldehyde, 2-hexenal, n-octylaldehyde, benzaldehyde, cuminaldehyde, anisaldehyde, chlorobenzaldehyde, cinnamaldehyde, crotonaldehyde, isobutyraldehyde, butyraldehyde, pyruvaldehyde, terephthalaldehyde, tolualdehyde, ethynyl phenyl ketone, furfural and mixtures of two or more of these aldehydes. Particularly preferred aldehyde compounds are aliphatic or aromatic aldehydes having 3 to 14 carbon atoms, and aliphatic aldehydes having 3 to 7 carbon atoms are still more preferable.

It is observed that the formation of a silver compound-alkylamine complex compound is completed in a very short time, typically in 10 minutes or less, in the presence of the ketone compounds and the aldehyde compounds. It is also observed that the complex compounds synthesized in the presence of the ketone compounds and the aldehyde compounds are quickly pyrolyzed to give coated silver fine particles having a small mean particle size of about 10 nm. In consideration of the general fact that the structure of a silver compound is destabilized by the formation of a good complex compound and consequently the silver compound is activated and comes to show a tendency to be pyrolyzed quickly even at a temperature that is equal to or lower than the usual pyrolysis temperature, it is assumed that the silver compound used in the invention is allowed to form a good complex compound microscopically in the presence of the ketone compounds and the aldehyde compounds.

Further, coated silver fine particles obtained by the thermal decomposition of a complex compound synthesized in the presence of the ketone compounds and the aldehyde compounds generally tend to be dispersed in organic solvents with a high concentration. Thus, the use of these compounds is effective particularly when the coated silver fine particles are used as inks in organic solvents.

Another of the compounds used in the formation of a silver compound-alkylamine complex compound in the invention is ester compounds represented by Formula (III):

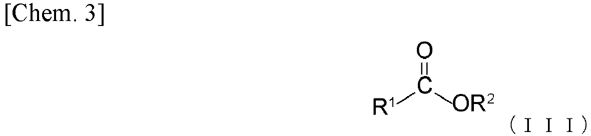

The ester compounds in the specification refer to carboxylate esters represented by Formula (III), in which R¹ and R² are as defined hereinabove. Non-limiting examples of the ester compounds suited for use in the inventive process include ethyl acetate, propylene carbonate, ethyl and methyl benzoates, ethyl p-methoxybenzoate, methyl p-ethoxybenzoate, ethyl p-ethoxybenzoate, ethyl acrylate, methyl methacrylate, ethyl acetate, ethyl p-chlorobenzoate, hexyl p-aminobenzoate, isopropyl naphthalate, n-amyl toluate, ethyl cyclohexanoate and propyl pivalate.

By the use of the ester compounds in which an oxygen atom is bonded to the carbonyl carbon, the time required for the formation of a complex compound may be decreased and the obtainable coated silver fine particles exhibit excellent sintering properties. On the other hand, the use of the ester compounds tends to result in an increase in the time required for the formation of a complex compound as compared to other compounds such as the ketone compounds and the aldehyde compounds in which an alkyl group or a hydrogen atom is bonded to the carbonyl carbon. This tendency is probably because the activity of the carbonyl oxygen is lowered as a result of the bonding of an oxygen atom to the carbonyl carbon.

Another of the compounds used in the formation of a silver compound-alkylamine complex compound in the invention is amide compounds in which a nitrogen atom is bonded to the carbonyl carbon. Typical examples thereof include carboxylic acid amide compounds represented by Formula (IV):

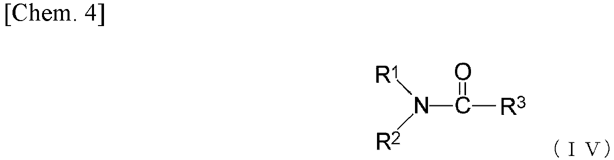

In Formula (IV), R¹, R² and R³ may be any of the groups defined for R¹ and R², a hydrogen atom and an amino group. A ring may be formed by a combination of R¹ and R², R¹ and R³, or R² and R³. Specific examples include cyclic lactam compounds and linear carboxylic acid amide compounds that are obtained by the dehydration condensation of at least one of ammonia, primary amines and secondary amines with carboxylic acids. Examples of the linear carboxylic acid amide compounds include formamide, acetamide, dimethylformamide, diethylformamide, N-methylformamide, N-ethylformamide, N-(2-hydroxyethyl)formamide and dimethylacetamide. Examples of the cyclic lactam compounds include 2-pyrrolidone, N-methylpyrrolidone, N-ethylpyrrolidone, N-propylpyrrolidone, 5-methyl-2-pyrrolidone, 5-ethyl-2-pyrrolidone, 5-propyl-2-pyrrolidone and γ-butyrocaprolactam.

Carbamide compounds represented by Formula (IV) in which R³ is an amino group or an alkylamino group may be used. Examples of the carbamide compounds include urea, uric acid, tetramethylcarbamide and dimethylimidazolidinone. However, the carbamide compounds are not limited thereto and other kinds of such compounds may be used in the invention. Further, imide compounds may be used in which two carbonyl groups are bonded to a primary amine or ammonia. The use of the amide compounds in which a nitrogen atom is bonded to the carbonyl carbon makes it possible to reduce the time required for the formation of a complex compound and also to produce coated silver fine particles suited for use as paste agents. In particular, coated silver fine particles produced using urea (a carbamide compound) or 2-pyrrolidone (a lactam compound) may afford paste agents which decrease the resistance value very quickly after being printed and have a low residual resistance.

Further, a silver compound-alkylamine complex compound may be formed in a short time by the use of an isocyanate compound (R-N=C=O) having a carbon-oxygen double bond and a carbon-nitrogen double bond in the molecule. Preferred examples of the isocyanate compounds for use in the process of the invention include methyl isocyanate, butyl isocyanate, hexyl isocyanate, 4-chlorophenyl isocyanate, phenyl isocyanate, cyclohexyl isocyanate, hexamethylene diisocyanate and octadecyl isocyanate. However, the isocyanate compounds are not limited thereto and other kinds of such compounds may be used. Cyanate compounds (R-O-C≡N) analogous to isocyanate compounds may be used similarly.

Examples of the compounds with a carbon-nitrogen multiple bond which may be used in the invention include oxime compounds and nitrile compounds.

The oxime compounds are organic compounds which have a structure represented by the general formula (>C=N-OH). Typical examples include ketoximes in which two organic groups are bonded to the carbon atom forming the double bond with the nitrogen atom, and aldoximes in which one of such organic groups is replaced by a hydrogen atom.

Suitable examples of the oxime compounds for use in the process of the invention include isobutyl methyl ketoxime, dimethylglyoxime, cyclohexanone oxime, methyl ethyl ketoxime, acetoxime and acetaldehyde oxime. Further, use is possible of Schiff bases in which the hydroxyl group (OH) in >C=N-OH is replaced by an organic group.

The nitrile compounds are compounds in which a substituent such as an alkyl group is bonded to the cyano group (-CN) formed of a carbon atom and a nitrogen atom. Preferred examples include acetonitrile, butyronitrile, acrylonitrile and benzonitrile. Because the nitrogen atom in the cyano group forms a triple bond with the carbon atom, the unshared electron pair on the nitrogen atom is exposed, and this is probably the reason why high activity is obtained. Compounds with an analogous structure may be used, with examples including isonitrile compounds having an isocyano group (-NC). Examples of the isonitrile compounds include cyclohexyl isonitrile and benzyl isonitrile.

In addition to the aforementioned compounds having a multiple bond between a heteroatom such as an oxygen atom or a nitrogen atom and a carbon atom, those compounds which have a heteroatom-heteroatom multiple bond may be effectively used in the formation of a silver compound-alkylamine complex compound in the invention.

Examples of the compounds having a heteroatom-heteroatom multiple bond include nitro compounds and nitroso compounds having an oxygen-nitrogen multiple bond. The nitro compounds are compounds in which a substituent such as an alkyl group is bonded to the nitro group (-NO₂), and the nitroso compounds are organic compounds in which a substituent such as an alkyl group is bonded to the nitroso group (-NO). Preferred examples of such compounds having an oxygen-nitrogen multiple bond include nitromethane, nitroethane, nitrobenzene and nitrosobenzene.

Examples of the compounds having a heteroatom-heteroatom multiple bond further include azo compounds, diazo compounds and azides having a nitrogen-nitrogen multiple bond. The azo compounds are such compounds in which a substituent such as an alkyl group or a phenyl group is bonded to the azo group (-N=N-). The diazo compounds are such compounds in which a substituent such as an alkyl group or a phenyl group is bonded to the diazo group (-N₂). The azides are compounds in which a substituent such as an alkyl group or a phenyl group is bonded to the azi group (-N₃), with examples including methyl azide, ethyl azide and azide diphenyl phosphate.

The aforementioned compounds having a specific multiple bond may be selected appropriately in accordance with factors such as the type of the alkylamine used and the desired properties of coated silver fine particles that are produced. A plurality of these compounds may be used in combination. Such a combined use may be adopted in consideration of not only the reaction time for the formation of a complex but also the type of the alkylamine and also the silver yield and the dispersibility of the coated silver fine particles.

As will be illustrated in Examples later, the extent to which the formation of a silver compound-alkylamine complex compound is accelerated and the properties of the obtainable complex compound or the obtainable coated silver fine particles are variable depending on the functional groups and the structures of the compounds with a specific multiple bond used in the invention. As mentioned earlier, a tendency is generally observed in which the effect in promoting the formation of a silver compound-alkylamine complex compound is reduced with increasing molecular weight. In view of this, the aforementioned compounds such as carbonyl compounds, oxime compounds and nitrile compounds preferably have 14 or less carbon atoms, more preferably 10 or less carbon atoms, still more preferably 6 to 8 or less carbon atoms, and most preferably 7 or less carbon atoms.

Part of the compound used in the formation of a complex compound is incorporated into the complex compound or the reaction medium used in the thermal decomposition of the complex compound. When the compound used has a high vapor pressure, the compound is vaporized and detached during the production of coated silver fine particles by the heating of the complex compound to destabilize the process of the formation of the coated silver fine particles and to decrease the yield of silver atoms recovered as the coated silver fine particles.

The formation of coated silver fine particles by the thermal decomposition of a complex compound is usually performed at a temperature in the range of about 70 to 150°C. It is therefore preferable that the compound added in the formation of a complex compound in the invention have a low vapor pressure in the above temperature range. Thus, the compounds used in the invention preferably have a boiling point of 70°C or more, and more preferably have a boiling point of 80°C or more.

For example, a low-boiling compound such as acetone tends to be vaporized when it is being mixed with the silver compound. Further, the use of such a compound tends to cause instability in the process of the decomposition of the complex compound. It is therefore preferable that when a low-boiling compound is used, the vapor pressure be reduced by using the low-boiling compound in combination with another compound such as a ketone compound, an aldehyde compound, a carboxylic acid amide compound or an ester, for example, acetylacetone, propionaldehyde or propylene carbonate.

In the invention, the compound with a specific multiple bond is added in such an amount that the compound may form a uniform mixture with components such as the alkylamine used in the formation of a complex compound, specifically, in an amount of about 5 mol% to 500 mol% relative to the alkylamine. If the molar ratio of the compound used is not more than 5 mol% relative to the alkylamine, the compound tends to exhibit an insufficient effect in promoting the formation of a complex compound. If, on the other hand, the molar ratio of the compound used is not less than 500 mol% relative to the alkylamine, the activity of the alkylamine tends to be decreased and the formation of a complex compound tends to be inhibited. Typically, the compound may be used in an amount of about 10 mol% to 300 mol% relative to the alkylamine. In this case, the formation of a complex compound is favorably promoted to afford a good complex compound. On the other hand, the amount of the compound is preferably about 25 mol% to 100 mol% relative to the alkylamine in order to obtain high efficiency in the formation of a complex compound and also to obtain satisfactory properties of the coating in coated silver fine particles. However, the specific type and amount of the compound are preferably selected and controlled appropriately in accordance with purposes such as the desired properties of coated silver fine particles that are produced.

In the invention, the compound with a specific multiple bond may be used in the formation of a silver compound-alkylamine complex compound in such a manner that the silver compound is added to a mixture of the alkylamine and the compound, such that the compound is mixed together with the silver compound to cause a change such as the breakage of the silver compound and thereafter the alkylamine is added to form a complex compound, or such that the compound is added to a mixture of the silver compound and the alkylamine to form a complex compound.

For purposes such as increasing the yield of coated silver fine particles and enhancing the uniformity of the particles, the compound may be added to a mixture which contains a complex compound being formed by the mixing of a silver compound and an alkylamine and thereby the silver compound may be treated during the occurrence of the complex-forming reaction.

### (Step of forming complex compound)

A silver compound-alkylamine complex compound is generally formed by mixing a powdery silver compound with a prescribed amount of an alkylamine. The invention is characterized in that the formation of the complex compound is promoted by the use of a specific alcohol compound or a specific compound with a multiple bond that is present in the reaction system. Such compounds may be added to the reaction system in an appropriate manner, for example, in such a manner that the compound is mixed with the alkylamine beforehand and the silver compound is added to the mixture, or such that mainly the compound is mixed with the silver compound to cause a change such as the disintegration of the powdery silver compound and thereafter the alkylamine is added to form a silver compound-alkylamine complex compound. Additional components such as water, alcohols and organic solvents may be admixed to the complex-forming reaction system.

During the process in which a silver compound-alkylamine complex compound is formed, the structures of a silver compound, for example, crystals thereof are broken and concurrently a complex compound is formed to exhibit a color which is generally determined in accordance with the types of the components constituting the complex compound. By utilizing this phenomenon, the end point of the complex-forming reaction may be determined by detecting the completion of the change in color of the reaction mixture using an appropriate technique such as spectrometry. A complex compound formed from silver oxalate that is mainly used in Examples later is generally colorless (white). Even in this case, the state of the complex-forming reaction may be detected based on changes in properties such as the viscosity of the mixture liquid.

In the invention, it is not always necessary that the formation of a complex compound has been completed before heating is performed to thermally decompose the complex compound. That is, the heating for the production of coated silver fine particles may be appropriately performed even during the formation of a complex compound. To ensure that silver atoms in the silver compound will be recovered as the coated silver fine particles in a high yield and also that the coated silver fine particles will exhibit uniform properties, it is preferable that a good complex compound be formed first and thereafter thermal decomposition of the complex be performed.

The formation of a complex compound is preferably performed at temperatures which do not induce the decomposition reaction of the silver compound or the vaporization of components such as the alkylamine. Typically, a complex compound may be formed by stirring at near room temperature. To promote the formation of a complex compound, heating may be performed while ensuring that undesired reactions such as the decomposition reaction of the silver compound do not occur. Because the coordination reaction of the alkylamine to the silver compound is exothermic, it is also preferable that the reaction mixture be stirred while being cooled to or below room temperature as required to suppress the occurrence of undesired reactions such as the decomposition reaction of the silver compound.

In the formation of a complex compound using components such as the silver compound and the alkylamine, the total amount of the alkylamine used is desirably at least stoichiometric with the metal silver atoms present in the silver compound. If the total amount of the alkylamine is less than stoichiometric with the metal silver atoms, part of the silver compound cannot form a complex compound to cause problems such as the coarsening of silver fine particles and the residual silver compound without being heat decomposed. Typically, silver fine particles with a uniform particle size may be obtained stably by using the alkylamine in a molar amount that is two times or more greater than the amount of the silver atoms in the formation of a complex compound. If the molar amount of the alkylamine is 5 times or more larger than the amount of the silver atoms, the density of the silver atoms in the reaction system is so reduced that the final yield of the silver atoms recovered is decreased. Further, such a heavy use of the alkylamine increases environmental loads. Thus, the molar amount of the alkylamine used is preferably not more than 5 times the amount of the silver atoms.

### (Step of thermal decomposition of complex compound)

The complex compound formed from the aforementioned components such as the silver compound and the alkylamine is heated to liberate the metal silver atoms in the silver compound and allow the silver atoms to aggregate into silver fine particles. In the production of coated silver fine particles by the silver amine complex decomposition process, the atomic silver is supplied by the thermal decomposition reaction of a previously formed single component (the complex compound). It is therefore assumed that nonuniformity is unlikely to be caused in the reaction due to variations in conditions such as the concentrations of components and consequently silver fine particles having a uniform particle size may be obtained stably as compared to when chemical reaction takes place among a plurality of components. Thus, the production of silver fine particles by the amine complex decomposition process is probably advantageous also in large-scale industrial production which encounters a particular difficulty in uniformly mixing a plurality of components to be involved in the reaction.

When the silver compound in the form of a complex compound as a result of the coordination bonding of the alkylamine is treated by a method such as thermal decomposition under appropriate conditions, the atomic silver is liberated. This liberation presumably takes place while the alkylamine molecule maintains the coordination bond via the amino group to the atomic silver that has been liberated. Consequently, the liberated silver atoms will be aggregated together to form aggregates in such a manner that the alkyl chains fixed by the coordination bonding of the amino groups are concentrated in a high density to form a coating on the periphery of the aggregates, and thus the growth of the silver fine particles to a size greater than the prescribed size is prevented. This is presumably the reason why the amine complex decomposition process can stably afford coated silver fine particles with a uniform particle size.

When, on the other hand, an alcoholic compound is present during the formation of a complex compound in the invention, part of the silver compound will form a complex compound with the alcoholic compound. Utilizing this phenomenon, use may be made of an appropriate alcoholic compound, for example, an alcoholic compound that is capable of coordinately bonding to the silver compound with a lower bond strength than does the alkylamine. Specifically, part of such an alcoholic compound is detached during the thermal decomposition of the complex compound and consequently only the silver atoms are allowed to aggregate. Therefore, it is likely that the mean particle size of the obtainable coated silver fine particles may be increased. In the process of the invention, it is also possible to control the sizes and the particle size distribution of the obtainable silver fine particles by appropriately selecting the type of the compound with a specific multiple bond. Although the mechanism of this control is not fully clear, one of the possibilities is such that the compound reacts or interacts with the alkylamine that is the protective molecule to affect the strength of the coordination bond of the alkylamine with the silver atom.

The silver amine complex decomposition process has a mechanism that provides a uniform size of silver fine particles formed as described above. Thus, the coarsening of the particles is prevented even in the case where the metal silver atoms are present in a high concentration As a result, the production of fine particles is possible with a smaller amount of a solvent than is used in conventional processes in which fine particles are produced while maintaining a low concentration of metal silver atoms by diluting the reaction system with a solvent. Further, it is also possible to stably recover the metal silver atoms as the silver fine particles in as high a yield as 95% or more.

Such coated silver fine particles are preferably produced by heating the complex compound formed as described hereinabove in the reaction medium containing the alkylamine. Specifically, components such as the alkylamine are added in excess over the silver compound to form a complex compound, and thereafter the complex compound may be heated while using the residual components such as the alkylamine as the reaction medium. Alternatively, appropriate components such as an alkylamine may be further mixed with the reaction medium as required. Still alternatively, coated silver fine particles may be produced in such a manner that the reaction mixture containing the complex compound is treated by a method such as centrifugation to separate the complex compound, and the complex compound is remixed with a reaction medium containing an appropriate alkylamine so as to replace part of the amine in the complex compound by the additionally added amine.

The atomic silver may be liberated from the complex compound at various temperatures depending on the type of the complex compound used. It is generally preferable that the temperature be immediately above a temperature at which the liberation of the atomic silver starts. On the other hand, excessive heating is prone to break the coordination bond of the alkylamine to the silver, and is thus disadvantageous in that the obtainable coated silver fine particles have an unstable coating and coarse particles are formed easily. In view of the fact that the vaporization of the components forming the reaction medium such as the alkylamine is activated at high temperatures, the liberation of the atomic silver from the complex compound preferably takes place at as low a temperature as possible in the range of temperatures which induce the liberation of atomic silver. Specifically, the silver compound in the complex compound is preferably decomposed by heating at temperatures in the range of 70 to 150°C, and more typically in the range of 80 to 120°C.

In the production of coated silver fine particles in the invention, silver oxalate is preferably used as the silver compound. Silver oxalate is usually decomposed at a temperature of about 200°C, and the oxalate ions are removed as carbon dioxide, leaving metal silver as the residue. In the process of the invention, silver oxalate may be formed into a complex compound with an amine mixture including prescribed amounts of an alkylamine and an alcoholic compound or a compound with a specific multiple bond. As a result of the complex formation, the oxalate ions may be heat decomposed at a temperature of about 100°C to liberate metal silver. For similar reasons as mentioned above, this temperature is preferably set as low as possible while the thermal decomposition of oxalate ions is still induced. However, an increase in temperature enhances the thermal decomposition rate and hence the heating temperature may be raised appropriately while still ensuring that good silver fine particles may be obtained.

The coated silver fine particles formed as described above are separated from the reaction medium including the alkylamine and are stored and used in the form of a mixture with an appropriate medium such as a dispersion medium in accordance with the application.

### (Dispersants)

The coated silver fine particles produced as described above may be stably dispersed with a high concentration in appropriate organic solvents, for example, alcohol solvents such as butanol, non-polar solvents such as octane, and mixtures of these solvents. The types of organic solvents in which the coated silver fine particles may be dispersed are variable depending on the selection of the components such as the alkylamine that have been used. The coated silver fine particles may be used as inks in the form of dispersions in appropriate organic solvents selected in accordance with the intended use. The organic solvents used are preferably those solvents which do not cause the detachment of components such as the alkylamine present in the protecting layer of the coated silver fine particles and also which are evaporated relatively quickly after the application of the dispersions. Some dispersants, for example fatty acids such as oleic acid may be mixed into the amine mixture as dispersants for enhancing the dispersibility of coated silver fine particles to be obtained into the dispersion media. In particular, it is effective to add an appropriate fatty acid when the amine mixture has a low average molecular weight of alkylamines due to reasons such as that the mixture contains a large proportion of a short chain alkylamine. However, the use of an excessively large amount of fatty acids tends to raise the temperature at which the protecting layer may be removed from the coated metal fine particles. It is therefore desirable that such a component be added in an amount of 5 mol% or less relative to the metal silver atoms present in the reaction system.

### (Coated silver fine particles)

Figs. 1 and 2 illustrate examples of coated silver fine particles produced by processes of the invention. Figs. 1 and 2 illustrate silver fine particles coated with an alkylamine-containing protecting layer that are produced by processes described in Examples later. In the coated silver fine particles, the particle sizes of the silver fine particles are about 5 to 500 nm. The particle sizes may be controlled by appropriately selecting the types of the alcoholic compounds and the compounds with a specific multiple bond. The surface of the particles is coated with an alkylamine-containing protecting layer with a thickness of about several nanometers, whereby the individual silver fine particles may be present independently and stably as shown in the images.

The coated silver fine particles produced as described above may be used in appropriate forms in accordance with properties and applications. For example, the coated silver fine particles may be applied to a prescribed shape by a method such as ink jetting and thereafter sintered at a low temperature to form a silver film. In this case, the amine used as the reaction medium may be replaced by a desired organic solvent and the coated silver fine particles dispersed in the organic solvent may be used as an ink-like dispersion. In this manner, the coated silver fine particles may be advantageously stored and used while ensuring that the coating will not be removed from the particles. Alternatively, the coated silver fine particles may be used as pastes by being mixed with appropriate media such as terpene oil. In the case where the coated silver fine particles have a coating based on a relatively long chain alkylamine, the amine used as the reaction medium may be removed and the coated silver fine particles may be stored as a powder.

In an embodiment of the process of the invention, coated silver fine particles are obtained by the thermal decomposition of a complex compound formed in the presence of a compound having a specific multiple bond. As will be demonstrated in Examples later, such coated silver fine particles exhibit variations in properties such as the dispersibility in media such as organic solvents and the residual resistance after calcination, depending on factors such as the types of the compounds used. These variations presumably indicate that the compounds used as well as derivatives thereof are incorporated together with the alkylamine into the coating of the coated silver fine particles.

### (Forming of conductor by sintering)

The coated silver fine particles produced by the invention may be heated at an appropriate temperature to detach the alkylamine forming the protecting layer. As a result, the silver fine particles are brought into direct contact with one another to form a conductor. For example, such a conductor may be formed at a temperature of about 100°C or below. This easy formation of the conductor is probably because the components forming the protecting layer such as the alkylamine are weakly bonded to the surface of the silver fine particles through the coordination bond via the amino group and are thus detached relatively easily by heating.

### (Substrates and methods for forming films containing coated silver fine particles)

Inks or pastes which contain the alkylamine-coated silver fine particles produced by the inventive process may be applied to substrates to form conductive films. The materials and the shapes of the substrates are not particularly limited. Examples of the materials include thermoplastic resins, thermosetting resins, glass, paper, metals, silicon and ceramics. Examples of the thermoplastic resins include polyethylenes, polyethylene terephthalates, polypropylenes, polyvinyl chlorides, polystyrenes, acrylonitrile-butadiene-styrene copolymer resins, acrylonitrile-styrene copolymer resins, polycarbonates, polyacetals, polybutylene terephthalates, polyphenylene oxides, polyamides, polyphenylene sulfides, polysulfones, polyether sulfones, polyether-ether ketones, polyarylates, aromatic polyesters, aromatic polyamides, fluororesins, polyvinylidene chlorides, polyvinyl alcohols, polyvinyl acetates, polyvinyl formals, polyvinyl butyrals, polymethyl methacrylates and cellulose acetates.

Examples of the thermosetting resins include phenolic resins, urea resins, xylene resins, urea resins, melamine resins, epoxy resins, silicone resins, diallyl phthalate resins, furan resins, aniline resins, acetone-formaldehyde resins and alkyd resins. Examples of the ceramics include inorganic compounds such as oxides, carbides, nitrides and borides, with specific examples including alumina (Al₂O₃), silicon nitride (SiN), silicon carbide (SiC), aluminum nitride (AlN) and zirconium boride (ZrB₂).

In the step in which an ink or the like containing the coated silver fine particles is applied to form an intended product such as a film on the substrate, any method may be adopted without limitation as long as the method can form a film with a desired thickness. General methods such as spin coating, bar coating and spraying may be used. In particular, various conventional printing methods may be used when a pattern as a wire precursor is formed on the substrate by the application of a film containing the coated silver fine particles. Examples of the printing methods for use in such a step include screen printing, ink jet printing, intaglio printing, letterpress printing and lithographic printing. The use applications of the metal films obtained by rendering the coated silver fine particles into conductive films are not limited to electric wires, and include mirrors for optical devices and various decorations.

The thickness of films formed on the substrates by applying an ink, a paste or the like containing the coated silver fine particles may be determined appropriately in accordance with the purposes of metal films obtained by rendering the particles conductive. In the case of usual electric wires or similar applications, the ink may be applied to form films such that the thickness of the metal films will be about 1 µm or less, or the paste may be applied to form films such that the thickness of the metal films will be about 1 to 50 µm, and such films may be processed to give conductive films having good properties.

Taking advantage of the fact that the coated silver fine particles have a very large specific surface area, an appropriate amount of the particles may be dispersed in water. Such an aqueous dispersion may be effectively used as a bactericidal agent exhibiting a strong bactericidal function with a small amount of the silver fine particles.

Further, the silver surface of the coated silver fine particles produced by the process of the invention is very clean and shows a characteristic plasmon. Utilizing these properties, the coated silver fine particles may be effectively used as coloring materials or as agents for enhancing photoelectric conversion efficiency in such fields as solar cells.

### EXAMPLES

Hereinbelow, the present invention will be described in further detail based on Examples and Comparative Examples illustrating processes for producing coated silver fine particles according to the invention. However, the scope of the invention is not limited to such Examples.

### Reference Example 1 and Examples 2 to 15

Coated silver fine particles of Reference Example 1 and Examples 2 to 15 were produced by the following process. As a silver compound, silver oxalate was used which had been synthesized from silver nitrate (KANTO CHEMICAL CO., LTD., first grade) and oxalic dihydrate (KANTO CHEMICAL CO., LTD., special grade). In each Example, 5.00 mmol (1.519 g) of silver oxalate was mixed together with a component(s) described in Table 1 such as an alcoholic compound, and further with an alkylamine, specifically, 20.0 mmol (2.024 g) of n-hexylamine (Tokyo Chemical Industry Co., Ltd., special grade) and, in order to enhance the dispersibility of the obtainable coated silver fine particles with respect to organic solvents, a fatty acid, specifically, 0.23 mmol (0.065 g) of oleic acid (Tokyo Chemical Industry Co., Ltd., >85.0%). The mixture was stirred at room temperature. In Reference Example 1, Examples 2 to 12 and 14, the amount of the alcoholic compound was 10 mmol. The solid alcoholic compounds such as phenol were dissolved in n-hexylamine beforehand, and silver oxalate was added to the solution. In Example 13, 1.32 g of polyethylene glycol with an average molecular weight of about 300 was added. Example 15 involved 8 mmol of ethylene glycol and 10 mmol of water.

By the stirring of the mixture liquid, the silver oxalate was dissolved and the entire liquid turned into a viscous white solution. The stirring was terminated when the change in appearance had come to an end. The white viscous product obtained by stirring the mixture of ethylene glycol and silver oxalate at room temperature for 70 minutes (the oleic acid-free system in Example 12) was analyzed by a diamond ATR technique (Nicolet 6700 FT-IR spectrometer) to measure its infrared absorption spectrum. It was then observed that the peak frequency assigned to the C=O stretching vibration of the oxalate ion had been shifted from 1562 in the case of the raw material silver oxalate to 1568 cm⁻¹. Further, the linewidth (half width) of the absorption band ascribed to the C=O stretching vibration was sharp and was approximately half of that in the case of the raw material silver oxalate. This indicates that the alkylamine and the alcohol had acted on (had been bonded to) the silver oxalate to cause changes in structure and electron state. The infrared absorption spectrum of this white viscous product also showed peaks assigned to n-hexylamine and ethylene glycol. Thus, it was evident that the residual was a mixture of the alkylamine and the alcoholic compound.

The mixture liquid containing the complex compound that was obtained above was transferred to an aluminum block hot stirrer (KOIKE PRECISION INSTRUMENTS) and was stirred while performing heating at a temperature of 110°C. The heating caused the reaction to proceed generating carbon dioxide. The stirring was continued until the generation of carbon dioxide came to an end, resulting in a suspension in which fine particles with a blue or green gloss were suspended in the mixture containing the alkylamine. In Reference Example 1, excess methanol was removed with an evaporator at 30°C before the mixture liquid was heated at 110°C.

Next, the dispersion medium of the suspension was replaced in the following manner. The suspension was combined with 10 mL of methanol (KANTO CHEMICAL CO., LTD., first grade), and the mixture was stirred. The coated silver fine particles were settled and separated by centrifugation (2600 G). To the coated silver fine particles separated, 10 mL of methanol was added again. The mixture was stirred and centrifuged to settle and separate the coated silver fine particles. To the coated silver fine particles, 0.5 mL of terpene dispersant Terusolve THA-70 (Nippon Terpene Chemicals, Inc.) was added. The mixture was stirred to give a paste containing the coated silver fine particles.

During the above process, the coated silver fine particles that had been separated were heated in a thermogravimetric analyzer (Shimadzu TGA-50) to remove the coating completely, and the weight of the metal silver present in the coated silver fine particles was measured, and the ratio thereof to the weight of the silver atoms present in the silver oxalate used in the production of the particles was evaluated. As a result, it was shown that at least 90 wt% of silver atoms were recovered as the coated silver fine particles regardless of the type of the alcoholic compound used. The silver content in the paste was about 70 wt%.

### [Evaluation results 1]

Regarding the coated silver fine particles produced in Reference Example 1 and Examples 2 to 15, Table 1 describes the time required to form the complex compound at room temperature during the production of the particles, and the time required for the complex compound to be decomposed at 110°C to afford silver fine particles.

**[Table 1]**

| | Alcoholic compounds and other components | Boiling point | Solubility (g/L) | Time required to form complex compound (min) | Time required to decompose complex compound (min) |
|---|---|---|---|---|---|
| Reference Example 1 | Methanol | 64.7 | ∞ | 30 | 8 |
| Example 2 | Ethanol | 78.4 | ∞ | 60 | 15 |
| Example 3 | n-propanol | 97.15 | ∞ | 120 | 12 |
| Example 4 | Isopropanol | 82.4 | 1000 | 90 | 10 |
| Example 5 | n-butanol | 117 | 77 | 90 | 8 |
| Example 6 | n-pentanol | 138 | 22 | 200 | 12 |
| Example 7 | n-hexanol | 157 | 6 | (200)^{*1} | 15 |
| Example 8 | n-octanol | 194 | 0.3 | (200)^{*1} | 20 |
| Example 9 | Phenol | 181.7 | 83 | 80 | 10 |
| Example 10 | Methoxyethanol | 124 | (Easily dissolved) | 80 | 15 |
| Example 11 | Triethylene glycol monomethyl ether | 245 | (Easily dissolved) | 80 | 8 |
| Example 12 | Ethylene glycol | 197.3 | (Easily dissolved) | 40 | 8 |
| Example 13 | Polyethylene glycol (#300) | ≈250 | ∞ | 7 | 8 |
| Example 14 | Glycerol | 290 | ∞ | 70 | 8 |
| Example 15 | Ethylene glycol + Water | --- | --- | 7 | 7 |
| Comparative example | (None) | --- | --- | (270)^{*1} | 30 |

| | | | | | |
|---|---|---|---|---|---|
| *1: The completion of the synthesis of the complex compound was not observed, and the synthesis was discontinued after the indicated time. | | | | | |

As shown in Table 1, the water-soluble alcoholic compounds and other components used in Examples promoted the formation of the complex compound between silver oxalate and n-hexylamine as compared to when no alcoholic compounds or other components were used (Comparative Example). In the case of hexanol (having 6 carbon atoms) or octanol (having 8 carbon atoms), part of the silver oxalate remained after the stirring for 200 minutes, but the amounts of the residual silver oxalate were smaller than that in Comparative Example. It was also observed that such residual silver oxalate was broken and disappeared during the heating of the mixture for the decomposition of the complex compound.

In each Example, the complex compound was decomposed in a shorter time than required in Comparative Example. It was thus assumed that the silver oxalate had been activated as a result of the promoted formation of the complex compound. In particular, Examples 12 to 15 which involved the polyhydric alcoholic compounds achieved a decrease in the time required to form the complex compound and also a decrease in the time required for the thermal decomposition of the complex compound. It was thus assumed that complex compounds had been synthesized successfully.

### [Evaluation results 2]

The pastes of the coated silver fine particles produced in Reference Example 1 and Examples 2 to 15 were each diluted with octane, dropped onto a collodion film (a copper mesh grid for transmission electron microscopic observation), and cleaned with methanol. Thereafter, the coated silver fine particles were observed on a scanning transmission electron microscope (STEM) (thermal field emission scanning electron microscope JSM-7600F, JEOL Ltd.), or were dropped onto an amorphous carbon support film (a copper mesh grid for transmission electron microscopic observation) and were observed on a transmission electron microscope (TEM) (field emission electron microscope JEM-2100F, JEOL Ltd.). The results are shown in Fig. 1. Table 2 describes the particle sizes approximately calculated with respect to these STEM images or TEM images.

The coated silver fine particles produced in Reference Example 1 and Examples 2 to 15 were shown to have a mean particle size of about 8 to 40 nm and a sharp particle size distribution.

### [Evaluation results 3]

The pastes of the coated silver fine particles produced in Reference Example 1 and Examples 2 to 15 were applied onto substrates and were sintered to evaluate sintering properties. The results are described in Table 2. In the evaluation, the paste was applied by bar coating onto a polyester film substrate (an OHP sheet) and was calcined at 100°C for 3 hours or 20 hours, and the resultant silver film was tested by a four probe method (K-705RS, Kyowa Riken Co., Ltd.) to measure the sheet resistance. In consideration of the film thickness of the calcined silver film, the volume resistivity was calculated using the sheet resistance of the silver film calcined for 20 hours.

**[Table 2]**

| Example | Mean particle size (nm) | Sheet resistance after 3 hours (Ω/□) | Sheet resistance after 20 hours (Ω/□) | Volume resistivity after 20 hours (µΩ·cm) |
|---|---|---|---|---|
| Reference Example 1 | 12.2 | 1.1 | 0.95 | 380 |
| Example 2 | 12.7 | 0.2 | 0.1 | 40 |
| Example 3 | 27.2 | 0.6 | 0.4 | 160 |
| Example 4 | 19.3 | 0.2 | 0.09 | 36 |
| Example 5 | 17.1 | --- | --- | ---^{*2} |
| Example 6 | 25.9 | --- | --- | ---^{*2} |
| Example 7 | 11.8 | --- | --- | ---^{*2} |
| Example 8 | 15.8 | --- | --- | ---^{*2} |
| Example 9 | 34.7 | 0.5 | 0.2 | 80 |
| Example 10 | 25.2 | 2.7 | 0.9 | 360 |
| Example 11 | 17.1 | --- | --- | ---^{*2} |
| Example 12 | 10.9 | 0.3 | 0.08 | 32 |
| Example 13 | 26.3 | 1.1 | 0.8 | 320 |
| Example 14 | 8.8 | 1.2 | 0.2 | 80 |
| Example 15 | 9.6 | 0.2 | 0.08 | 32 |
| Comparative example | 11.7 | 2.9 | 1.0 | 400 |

| | | | | |
|---|---|---|---|---|
| *2: The sintered film had fine cracks and the measurement of the resistance value was difficult. | | | | |

As shown in Table 2, the complex compounds synthesized using the alcoholic compounds generally afforded sintered silver films having a lower residual resistance as compared to Comparative Example which did not involve any alcoholic compounds. In Examples 5 to 8 and 11, the silver films obtained by the sintering of the coated silver fine particles had a great number of cracks, and thus it was difficult to measure the macroscopic resistance value.

### [Examples 16 to 40]

Coated silver fine particles of Examples 16 to 40 were produced by the following process. As a silver compound, silver oxalate was used which had been synthesized from silver nitrate (KANTO CHEMICAL CO., LTD., first grade) and oxalic dihydrate (KANTO CHEMICAL CO., LTD., special grade). In each Example, 5.00 mmol (1.519 g) of silver oxalate was mixed together with a compound(s) described in Table 3, an alkylamine, specifically, 20.0 mmol of n-hexylamine (Tokyo Chemical Industry Co., Ltd., special grade) [Examples 16, 17 and 19 to 40] or 20.0 mmol of n-octylamine (Tokyo Chemical Industry Co., Ltd., special grade) [Example 18] and, in order to enhance the dispersibility of the obtainable coated silver fine particles with respect to organic solvents, a fatty acid, specifically, 0.065 g (0.23 mmol) of oleic acid (Tokyo Chemical Industry Co., Ltd., >85.0%). The mixture was stirred at room temperature. In Comparative Example 2, only silver oxalate, n-hexylamine and oleic acid were mixed together in the same amounts as described above, and the mixture was stirred at room temperature. In Examples 16 to 36, the amount of the additive compound was 10 mmol. In Examples 37 to 40, two types of the additive compounds were mixed together each in an amount of 5 mmol.

In Examples 16 to 40 and Comparative Example 2, the mixture liquid containing the silver oxalate turned into a viscous solution during stirring. The stirring was terminated when the change in appearance had come to an end. In Table 3, the stirring time is written as the time required to form the complex compound in the presence of the indicated additive compound(s):

The white viscous product obtained above was analyzed by a diamond ATR technique (Nicolet 6700 FT-IR spectrometer) to measure its infrared absorption spectrum. It was observed that regardless of the types of the additive compounds, the absorption peak frequency assigned to the C=O stretching vibration in the oxalate ion had been shifted to a higher frequency side, and the linewidth (half width) of the absorption band was approximately half of that in the case of the raw material silver oxalate. This indicates that the mixing of the silver oxalate with the components such as the alkylamine by stirring in the way mentioned above caused the components such as the alkylamine to be coordinately bonded to the silver oxalate, while the structure of the silver oxalate was maintained, thereby causing changes in structures such as in the electron state of the silver oxalate.

The mixture liquid containing the complex compound that was obtained above was transferred to an aluminum block hot stirrer (KOIKE PRECISION INSTRUMENTS) and was stirred while performing heating at a temperature of 110°C. The heating caused the reaction to proceed generating carbon dioxide. The stirring was continued until the generation of carbon dioxide came to an end, resulting in a suspension in which silver fine particles with a blue or green gloss were suspended in the mixture containing the alkylamine. In Examples in which the compound used had a high vapor pressure, the high-vapor pressure component was removed with an evaporator at 30°C before the mixture was heated at 110°C. In Table 3, the time to the completion of carbon dioxide generation is written as the time required to decompose the complex compound prepared using the indicated additive compound(s).

Next, the suspension was combined with 10 mL of methanol (KANTO CHEMICAL CO., LTD., first grade), and the mixture was stirred. The silver fine particles were settled and separated by centrifugation (2600 G). To the silver fine particles separated, 10 mL of methanol was added again. The mixture was stirred and centrifuged to settle and separate the silver fine particles, and a paste of the coated silver fine particles was obtained.

### (Evaluation of silver yield)

The coated silver fine particles in the form of a paste were heated in a thermogravimetric analyzer (Shimadzu TGA-50) to remove completely the coating of the coated silver fine particles, and the weight of the metal silver present in the coated silver fine particles was measured. As a result, it was shown that at least 95% of the silver atoms present in the raw material silver oxalate were recovered as the coated silver fine particles regardless of the production conditions.

### (Evaluation of properties such as particle size of coated silver fine particles)

The coated silver fine particles produced in Examples 16 to 40 and Comparative Example 2 were each dispersed in octane. The dispersion was dropped onto a collodion film (a copper mesh grid for transmission electron microscopic observation), cleaned with methanol, and observed on a scanning transmission electron microscope (STEM) or a scanning electron microscope (SEM) (thermal field emission scanning electron microscope JSM-7600F, JEOL Ltd.). The results are shown in Fig. 2. Table 4 describes the particle sizes approximately calculated with respect to these STEM images or SEM images.

### (Evaluation of dispersibility in solvents)

The coated silver fine particles obtained above were tested as described below to evaluate the dispersibility with respect to solvents. To the whole amount of the paste of the coated silver fine particles obtained above, 3 mL of a mixed solvent was added which contained butanol (KANTO CHEMICAL CO., LTD., special grade) and octane (GODO CO., LTD.) (volume ratio 1:4). The mixture was stirred and was centrifuged to settle and remove poorly dispersible particle components. A saturated dispersion was thus obtained. The amount of the silver fine particles in the dispersion was measured to evaluate the dispersibility with respect to solvents. The above amount of the mixed solvent corresponds to an amount that will allow approximately the whole amount of coated silver fine particles with highest dispersibility to be dispersed therein.

The evaluation results showed that the dispersibility of the coated silver fine particles with respect to the mixed solvent was variable depending on the types of the compounds added during the formation of the silver oxalate-alkylamine complex. Specifically, in the case of coated silver fine particles with excellent dispersibility, substantially the whole amounts of the particles were dispersed independently in the mixed solvent to give a dispersion exhibiting a dark yellowish orange color as a whole. Depending on the types of the additive components, on the other hand, some of the dispersions exhibited a low degree of coloration of the solvent and also contained a visible sedimentation.

Of the dispersions obtained above, those in which the particles exhibited relatively good dispersibility were cleaned of any sedimentation and were thereafter heated in a thermogravimetric analyzer (Shimadzu TGA-50) to remove completely the mixed solvent and the coating of the coated silver fine particles. The weight of the metal silver that had been present in the dispersion was measured, and the weight ratio of the silver fine particles relative to the dispersion (saturated dispersion ratio, wt%) was obtained. The results are described in Table 3. As described in Table 3, the dispersions in which substantially the whole amounts of the coated silver fine particles were dispersed were shown to contain the silver fine particles in as high a ratio as 30 wt% or more.

### (Evaluation of sintering properties)

The sintering properties of the coated silver fine particles obtained above were evaluated in the following manner. For those coated silver fine particles which had been evaluated to be dispersible in the mixed solvent approximately with a ratio of 15 wt% or more, the saturated dispersion of the particles in the mixed solvent was used as an ink in the evaluation of sintering properties. Those coated silver fine particles which had been shown to be incapable of forming a high-concentration dispersion were combined with, in place of the mixed solvent, 0.5 mL of terpene dispersant Terusolve THA-70 (Nippon Terpene Chemicals, Inc.) such that the weight ratio of the silver fine particles would be about 65 wt%, and the mixture was stirred to give a silver fine particle paste for use in the evaluation of sintering properties.

**[Table 3]**

| Example No. | Additive compounds | Additive component classification | Time required to form complex compound (min) | Time required to decompose complex compound (min) | Saturated dispersion ratio (wt%) |
|---|---|---|---|---|---|
| Example 16 | Acetone | Ketones | 2 | 5 | 19 |
| Example 17 | Acetylacetone | | 5 | 5 | 29 |
| Example 18 | Acetylacetone^{*1} | | 12 | 8 | 36 |
| Example 19 | 2-Butanone | | 2 | 8 | 26 |
| Example 20 | 3-Pentanone | | 8 | 8 | 26 |
| Example 21 | 4-Heptanone | | 8 | 8 | 17 |
| Example 22 | Acetophenone | | 150 | 9 | 31 |
| Example 23 | Mesityl oxide | | 10 | 8 | 30 |
| Example 24 | Propionaldehyde | Aldehydes | 2 | 5 | 28 |
| Example 25 | Hexanal | | 5 | 8 | 32 |
| Example 26 | Cumin aldehyde | | 5 | 10 | 28 |
| Example 27 | Urea | Amides | 30 | 8 | --- |
| Example 28 | N,N-dimethylformamide | | 50 | 20 | --- |
| Example 29 | N,N-dimethylacetamide | | 90 | 20 | --- |
| Example 30 | 2-Pyrrolidone | | 50 | 10 | --- |
| Example 31 | Propylene carbonate | Esters | 200 | 30 | 16 |
| Example 32 | Ethyl acetate | | 240 | 40 | --- |
| Example 33 | Ethyl isocyanate | Isocyanate | 10 | 7 | 25 |
| Example 34 | Acetonitrile | Nitrile | 50 | 30 | --- |
| Example 35 | Methyl ethyl ketoxime | Oxime | 120 | 7 | --- |
| Example 36 | Nitromethane | Nitro | 60 | 8 | --- |
| Example 37 | Acetone + Acetylacetone | | 3 | 5 | 29 |
| Example 38 | Acetone + Acetophenone | | 25 | 6 | 32 |
| Example 39 | Acetone + Propionaldehyde | | 2 | 5 | 28 |
| Example 40 | Acetone + Propylene carbonate | | 5 | 10 | 31 |
| Comparative example 2 | None | --- | 270^{*2} | 30 | --- |

| | | | | | |
|---|---|---|---|---|---|
| *1: N-octylamine was used in place of n-hexylamine as the protective molecules. *2: The completion of the formation of the complex compound was not observed, and the stirring was discontinued after the indicated time. | | | | | |

In the evaluation of sintering properties, the dispersions and the pastes were each applied onto a polyester film substrate (an OHP sheet) by spin coating for the dispersions (the inks) or by bar coating for the pastes. The films were calcined at 100°C for 3 hours or 20 hours, and the silver films resulting from the calcination of the coated silver fine particles were tested by a four probe method (K-705RS, Kyowa Riken Co., Ltd.) to measure the sheet resistance. Further, the film thickness of the respective silver films was measured with a thickness meter, and the volume resistivity of the silver films obtained by calcination for 20 hours was calculated using the measured thickness value.

Table 4 describes the sheet resistance, the volume resistivity and the average film thickness measured above with respect to the coated silver fine particles produced in Examples 16 to 40 and Comparative Example 2.

**[Table 4]**

| Example No. | Additive components | Mean particle size (nm) | Resistance value (Ω/□) after 3 hours | Resistance value (Ω/□) after 20 hours | Average film thickness (×10² nm) | Volume resistivity (µΩ·cm) after 20 hours |
|---|---|---|---|---|---|---|
| Example 16 | Acetone | 13.9 | 0.85 | 0.41 | 2.5(Ink) | 10 |
| Example 17 | Acetylacetone | 10.6 | 0.89 | 0.12 | 3.5(Ink) | 4.2 |
| Example 18 | Acetylacetone^{*1} | 10.4 | 1.65 | 1.00 | 4.1(Ink) | 41 |
| Example 19 | 2-Butanone | 9.6 | 0.79 | 0.50 | 3.3(Ink) | 17 |
| Example 20 | 3-Pentanone | 9.1 | 1.11 | 0.68 | 2.7(Ink) | 18 |
| Example 21 | 4-Heptanone | 9.5 | 1.62 | 1.05 | 1.7(Ink) | 18 |
| Example 22 | Acetophenone | 10.7 | 0.22 | 0.17 | 3.8(Ink) | 6.5 |
| Example 23 | Mesityl oxide | 10.9 | 0.25 | 0.20 | 5.0(Ink) | 10 |
| Example 24 | Propionaldehyde | 10.8 | 0.95 | 0.32 | 4.3(Ink) | 14 |
| Example 25 | Hexanal | 8.4 | 0.74 | 0.46 | 2.7(Ink) | 12 |
| Example 26 | Cumin aldehyde | 12.9 | --- | --- | 2.8(Ink) | --- |
| Example 27 | Urea | 20/100 | 0.037 | 0.015 | 40(Paste) | 6.0 |
| Example 28 | N,N-dimethylformamide | 11.8 | --- | --- | 40(Paste) | --- |
| Example 29 | N,N -dimethylacetamide | 13.6 | --- | --- | 40(Paste) | --- |
| Example 30 | 2-Pyrrolidone | 10/40 | 0.05 | 0.03 | 40(Paste) | 12 |
| Example 31 | Propylene carbonate | 10.3 | ∞ | 1.02 | 1.9(Ink) | 20 |
| Example 32 | Ethyl acetate | 12.0 | 0.45 | 0.26 | 40(Paste) | 100 |
| Example 33 | Ethyl isocyanate | 11.6 | 0.53 | 0.45 | 3.3(Ink) | 15 |
| Example 34 | Acetonitrile | 12.6 | 0.36 | 0.26 | 40(Paste) | 104 |
| Example 35 | Methyl ethyl ketoxime | 10.6 | 0.13 | 0.05 | 40(Paste) | 20 |
| Example 36 | Nitromethane | 8.3 | 0.16 | 0.06 | 40(Paste) | 24 |
| Example 37 | Acetone + Acetylacetone | 12.3 | 0.31 | 0.11 | 3.6(Ink) | 4.0 |
| Example 38 | Acetone + Acetophenone | 10.6 | 0.78 | 0.52 | 3.8(Ink) | 20 |
| Example 39 | Acetone + Propionaldehyde | 9.0 | 0.23 | 0.085 | 4.1(Ink) | 3.5 |
| Example 40 | Acetone + Propylene carbonate | 9.7 | 3.59 | 0.14 | 2.9(Ink) | 4.1 |
| Comparative example 2 | None | 11.7 | 2.90 | 0.96 | 40(Paste) | 380 |

| | | | | | | |
|---|---|---|---|---|---|---|
| * 1: N-octylamine was used in place of n-hexylamine as the protective molecules. | | | | | | |

As shown in Tables 3 and 4, silver oxalate and n-hexylamine or n-octylamine were allowed to form a complex compound in a markedly short time when the synthesis involved the addition of a carbonyl compound, namely, a ketone compound (Examples 16 to 23) or an aldehyde compound (Examples 24 to 26), and such complex compounds were decomposed in a markedly short time. In these Examples, the mean particle sizes of the coated silver fine particles were generally as small as about 10 nm. Further, the coated silver fine particles were dispersible in the mixed solvent with a high concentration.

When, on the other hand, carbonyl compounds having an amide moiety in the molecule were added (Examples 27 to 30), the formation and the decomposition of the complex compounds tended to require a longer time than when the ketones or the aldehydes were used. Further, the use of such compounds tended to result in coated silver fine particles which were suited for use as pastes in view of their dispersibility in the mixed solvent.

Regarding the particle size distribution of the produced particles, the use of compounds having an amide moiety, namely, urea (Example 27) and 2-pyrrolidone (Example 30) resulted in coated silver fine particles which were a mixture of particles having a relatively small mean particle size (about 10 to 20 nm) and particles having a relatively large mean particle size (about 30 to 100 nm) (Figs. 2 (e) and (g)). It was shown that when the pastes containing these coated silver fine particles were applied to the substrates, the electric resistance decreased quickly and the residual resistance after prolonged calcination was low. Fig. 3 is an electron microscope (SEM) image illustrating the surface of the silver film after the sintering of the coated silver fine particles obtained in Example 27.

The above phenomena are probably associated with the facts that the thickness of the coating is constant regardless of the particle sizes of the coated silver fine particles and is approximately equal to the length of the alkylamine molecules, and hence the volume ratio of the coating is low in the case of coated silver fine particles having a relatively large particle size. Further, the decrease in resistance values is probably contributed to by the fact that when the particles are a mixture containing relatively large particles and a certain proportion of relatively small particles, such small particles fill the gaps between the larger particles and consequently there is not much change in the diffusion length that the silver atoms must travel to form bonds between particles, as compared to when the particles have a uniform and small mean particle size.

On the other hand, the use of other types of compounds having an amide moiety such as dimethylacetamide (Examples 28 and 29) tended to result in the occurrence of fine cracks in the silver films produced by calcination at 100°C, and the evaluation of resistance values was difficult.

In the case of ester compounds (Examples 31 and 32) belonging to carbonyl compounds, mainly the formation of the complex compounds tended to require a longer time as compared to when other types of carbonyl compounds were used. However, the coated silver fine particles obtained exhibited good performance such as low residual resistance of the silver films obtained by the sintering of the coated silver fine particles.

Further, the time required for, in particular, the formation of the silver oxalate-alkylamine complex compound was decreased, and good coated silver fine particles were produced in a high yield by the use of compounds having a carbon-nitrogen multiple bond (Examples 34 and 35), compounds having a heteroatom-heteroatom multiple bond (Example 36), and compounds having a carbon-oxygen double bond and a carbon-nitrogen double bond in the molecule (Example 33).

Further, the time required for the formation of the complex compounds was effectively decreased, and good coated silver fine particles were produced by the use of a mixture containing a plurality of additive compounds capable of promoting the formation of complex compounds (Examples 37 to 40).

## Claims

1. A process for producing coated silver fine particles comprising:
a first step of forming a complex compound comprising a silver compound and an alkylamine by mixing
(1) a silver compound capable of generating metal silver by thermal decomposition,
(2) an alkylamine represented as an alkylamine RNH₂ having a primary amino group in the amine moiety or alkylamines RR'NH having a secondary amino group in the amine moiety, wherein R and R' each independently indicate a hydrocarbon group, and
(3) at least one alcoholic compound having a solubility in water and has a boiling point of 70°C or more and/or a compound having at least one of a carbon-heteroatom multiple bond and a heteroatom-heteroatom multiple bond in the molecule, and
a second step of generating silver fine particles coated with a protecting layer including the alkylamine by thermal decomposition of the complex compound,
wherein the compound having a carbon-heteroatom bond or a heteroatom-heteroatom multiple bond in the molecule is selected from the group consisting of ketone compounds, aldehyde compounds, ester compounds, amide compounds, carbamide compounds, imide compounds, oxime compounds, nitrile compounds, isonitrile compounds, isocyanates compounds, cyanate compounds, azo compounds, nitro compounds, nitroso compounds and azides; and
wherein the amount of alcoholic compound and/or a compound having at least one of a carbon-heteroatom multiple bond and a heteroatom-heteroatom multiple bond is 5 mol% to 500 mol% relative to the alkylamine.

2. The process for producing coated silver fine particles according to claim 1, wherein at least one of the alcoholic compound(s) has a solubility in water at 20°C of 0.3 g/L or more.

3. The process for producing coated silver fine particles according to any one of claims 1 to 2, wherein at least one of the alcoholic compound(s) is a polyhydric alcohol.

4. The process for producing coated silver fine particles according to any one of claims 1 to 3, wherein the mixing in the first step further involves a fatty acid.

5. The process for producing coated silver fine particles according to any one of claims 1 to 4, wherein the mixing in the first step further involves water.

6. The process according to claim 1, wherein the heteroatom is at least one of oxygen atom and nitrogen atom.

7. The process according to claim 1 or 6, wherein the compound having at least one of a carbon-heteroatom multiple bond and a heteroatom-heteroatom multiple bond in the molecule has 14 or less carbon atoms.

8. The process according to any one of claims 1, 6 and 7, wherein the first step is carried out using at least one compound having a carbon-heteroatom multiple bond in the molecule which compound is selected from the group consisting of ketone compounds, aldehyde compounds, ester compounds, amide compounds, carbamide compounds, imide compounds, oxime compounds, nitrile compounds, isonitrile compounds, isocyanates and cyanate compounds.

9. The process according to any one of claims 1 and 6 to 8, wherein the first step is carried out using at least one compound having a heteroatom-heteroatom multiple bond in the molecule which compound is selected from the group consisting of azo compounds, nitro compounds, nitroso compounds and azides.

10. The process according to any one of claims 1 to 9, wherein the silver compound comprises silver oxalate as a main component.

11. A paste comprising silver fine particles coated with a protecting layer including an alkylamine, wherein the silver fine particles are obtainable by the processes of claim 1-10, and wherein the at least one alcoholic compound having a solubility in water and/or the compound having at least one of a carbon-heteroatom multiple bond and a heteroatom-heteroatom multiple bond in the molecule is introduced into the coating of the silver fine particles.

12. The paste according to claim 11, wherein the mean particle size of the silver fine particles is larger than 30 nm, the mean particle size being measured by dispersing the coated silver fine particles in octane, dropping said dispersion onto a collodion film (a copper mesh grid for transmission electron microscopic observation), cleaning with methanol and observing on a scanning transmission electron microscope (STEM) or a scanning electron microscope (SEM).

## Patentansprüche

1. Verfahren zur Herstellung von beschichteten Silberfeinteilchen, Folgendes umfassend:
einen ersten Schritt des Herstellens einer Komplexverbindung, die eine Silberverbindung und ein Alkylamin umfasst, durch Vermischen von
(1) einer Silberverbindung, die zur Bildung von metallischem Silber durch thermische Zersetzung in der Lage ist,
(2) einem Alkylamin, dargestellt als Alkylamin RNH₂ mit einer primären Aminogruppe in der Amingruppierung oder als Alkylamine RR'NH mit einer sekundären Aminogruppe in der Amingruppierung, worin R und R' jeweils unabhängig voneinander für eine Kohlenwasserstoffgruppe stehen, und
(3) zumindest einer Alkoholverbindung, die Wasserlöslichkeit und einen Siedepunkt von 70 °C oder mehr aufweist, und/oder einer Verbindung mit zumindest einer aus einer Kohlenstoff-Heteroatom-Mehrfachbindung und einer Heteroatom-Heteroatom-Mehrfachbindung im Molekül; und
einen zweiten Schritt des Herstellens von Silberfeinteilchen, die mit einer das Alkylamin umfassenden Schutzschicht beschichtet sind, durch thermische Zersetzung der Komplexverbindung,
wobei die Verbindung mit einer Kohlenstoff-Heteroatom-Bindung oder einer Heteroatom-Heteroatom-Mehrfachbindung im Molekül aus der aus Ketonverbindungen, Aldehydverbindungen, Esterverbindungen, Amidverbindungen, Carbamidverbindungen, Imidverbindungen, Oximverbindungen, Nitrilverbindungen, Isonitrilverbindungen, Isocyanatverbindungen, Cyanatverbindungen, Azoverbindungen, Nitroverbindungen, Nitrosoverbindungen und Aziden bestehenden Gruppe ausgewählt ist; und
wobei die Menge der Alkoholverbindung und/oder der Verbindung mit zumindest einer aus einer Kohlenstoff-Heteroatom-Mehrfachbindung und einer Heteroatom-Heteroatom-Mehrfachbindung 5 bis 500 Mol-%, bezogen auf das Alkylamin, beträgt.

2. Verfahren zur Herstellung von beschichteten Silberfeinteilchen nach Anspruch 1, wobei zumindest eine der Alkoholverbindungen bei 20 °C eine Wasserlöslichkeit von 0,3 g/l oder mehr aufweist.

3. Verfahren zur Herstellung von beschichteten Silberfeinteilchen nach einem der Ansprüche 1 bis 2, wobei zumindest eine der Alkoholverbindungen ein mehrwertiger Alkohol ist.

4. Verfahren zur Herstellung von beschichteten Silberfeinteilchen nach einem der Ansprüche 1 bis 3, wobei das Vermischen im ersten Schritt weiters eine Fettsäure umfasst.

5. Verfahren zur Herstellung von beschichteten Silberfeinteilchen nach einem der Ansprüche 1 bis 4, wobei das Vermischen im ersten Schritt weiters Wasser umfasst.

6. Verfahren nach Anspruch 1, wobei das Heteroatom zumindest eines aus einem Sauerstoffatom und einem Stickstoffatom ist.

7. Verfahren nach Anspruch 1 oder 6, wobei die Verbindung mit zumindest einer aus einer Kohlenstoff-Heteroatom-Mehrfachbindung und einer Heteroatom-Heteroatom-Mehrfachbindung im Molekül 14 oder weniger Kohlenstoffatome aufweist.

8. Verfahren nach einem der Ansprüche 1, 6 und 7, wobei der erste Schritt unter Verwendung zumindest einer Verbindung mit einer Kohlenstoff-Heteroatom-Mehrfachbindung im Molekül durchgeführt wird, wobei die Verbindung aus der aus Ketonverbindungen, Aldehydverbindungen, Esterverbindungen, Amidverbindungen, Carbamidverbindungen, Imidverbindungen, Oximverbindungen, Nitrilverbindungen, Isonitrilverbindungen, Isocyanaten und Cyanatverbindungen bestehenden Gruppe ausgewählt ist.

9. Verfahren nach einem der Ansprüche 1 und 6 bis 8, wobei der erste Schritt unter Verwendung zumindest einer Verbindung mit einer Heteroatom-Heteroatom-Mehrfachbindung im Molekül durchgeführt wird, wobei die Verbindung aus der aus Azoverbindungen, Nitroverbindungen, Nitrosoverbindungen und Aziden bestehenden Gruppe ausgewählt ist.

10. Verfahren nach einem der Ansprüche 1 bis 9, wobei die Silberverbindung Silberoxalat als Hauptkomponente umfasst.

11. Paste, die Silberfeinteilchen mit einer ein Alkylamin umfassenden Schutzschicht umfasst, wobei die Silberfeinteilchen durch ein Verfahren nach einem der Ansprüche 1 bis 10 erhältlich sind und wobei die zumindest eine Alkoholverbindung, die Wasserlöslichkeit aufweist, und/oder die Verbindung mit zumindest einer aus einer Kohlenstoff-Heteroatom-Mehrfachbindung und einer Heteroatom-Heteroatom-Mehrfachbindung im Molekül in die Beschichtung der Silberfeinteilchen eingeführt ist.

12. Paste nach Anspruch 11, wobei die mittlere Teilchengröße der Silberfeinteilchen größer als 30 nm ist, wobei die mittlere Teilchengröße durch Dispergieren der beschichteten Silberfeinteilchen in Octan, Auftropfen der Dispersion auf einen Kollodiumfilm (ein Kupferdrahtgitter zur transmissionselektronenmikroskopischen Beobachtung), Reinigen mit Methanol und Beobachten auf einem Rastertransmissionselektronenmikroskop (STEM) oder Rasterelektronenmikroskop (SEM) gemessen wird.

## Revendications

1. Procédé de production de fines particules d'argent revêtues comprenant :
une première étape de formation d'un composé complexe comprenant un composé d'argent et une alkylamine en mélangeant
(1) un composé d'argent capable de générer de l'argent métallique par décomposition thermique,
(2) une alkylamine représentée sous la forme d'une alkylamine RNH₂ ayant un groupe amino primaire dans la fraction amine ou d'alkylamines RR'NH ayant un groupe amino secondaire dans la fraction amine, dans lequel R et R' indiquent chacun indépendamment un groupe hydrocarboné, et
(3) au moins un composé alcoolique ayant une solubilité dans l'eau et ayant un point d'ébullition de 70°C ou plus et/ou un composé ayant au moins une liaison multiple carbone-hétéroatome et une liaison multiple hétéroatome-hétéroatome dans la molécule, et
une seconde étape de génération de fines particules d'argent revêtues d'une couche protectrice comprenant l'alkylamine par décomposition thermique du composé complexe,
dans lequel le composé ayant une liaison carbone-hétéroatome ou une liaison multiple hétéroatome-hétéroatome dans la molécule est choisi dans le groupe constitué par des composés de cétone, des composés d'aldéhyde, des composés d'ester, des composés d'amide, des composés de carbamide, des composés d'imide, des composés d'oxime, des composés de nitrile, des composés d'isonitrile, des composés d'isocyanates, des composés de cyanate, des composés azo, composés nitro, composés nitroso et des azotures ; et
dans lequel la quantité de composé alcoolique et/ou d'un composé ayant au moins une liaison multiple carbone-hétéroatome et une liaison multiple hétéroatome-hétéroatome est de 5 % en mole à 500 % en mole par rapport à l'alkylamine.

2. Procédé de production de fines particules d'argent revêtues selon la revendication 1, dans lequel au moins l'un des composés alcooliques a une solubilité dans l'eau à 20°C de 0,3 g/L ou plus.

3. Procédé de production de fines particules d'argent revêtues selon l'une quelconque des revendications 1 à 2, où au moins l'un des composés alcooliques est un alcool polyhydrique.

4. Procédé de production de fines particules d'argent revêtues selon l'une quelconque des revendications 1 à 3, dans lequel le mélange dans la première étape implique en outre un acide gras.

5. Procédé de production de fines particules d'argent revêtues selon l'une quelconque des revendications 1 à 4, dans lequel le mélange dans la première étape implique en outre de l'eau.

6. Procédé selon la revendication 1, dans lequel l'hétéroatome est au moins l'un parmi un atome d'oxygène et un atome d'azote.

7. Procédé selon la revendication 1 ou 6, dans lequel le composé ayant au moins une liaison multiple carbone-hétéroatome et une liaison multiple hétéroatome-hétéroatome dans la molécule a 14 atomes de carbone ou moins.

8. Procédé selon l'une quelconque des revendications 1, 6 et 7, dans lequel la première étape est effectuée en utilisant au moins un composé ayant une liaison multiple carbone-hétéroatome dans la molécule, lequel composé est choisi dans le groupe constitué par des composés de cétone, des composés d'aldéhyde, des composés d'ester, des composés d'amide, des composés de carbamide, des composés d'imide, des composés d'oxime, des composés de nitrile, des composés d'isonitrile, des composés d'isocyanates et des composés de cyanate.

9. Procédé selon l'une quelconque des revendications 1 et 6 à 8, dans lequel la première étape est effectuée en utilisant au moins un composé ayant une liaison multiple hétéroatome-hétéroatome dans la molécule, lequel composé est choisi dans le groupe constitué par des composés azo, des composés nitro, des composés nitro et azotures.

10. Procédé selon l'une quelconque des revendications 1 à 9, dans lequel le composé d'argent comprend de l'oxalate d'argent comme composant principal.

11. Pâte comprenant de fines particules d'argent revêtues d'une couche protectrice comprenant une alkylamine, dans laquelle les fines particules d'argent peuvent être obtenues par les procédés selon les revendications 1 à 10, et dans laquelle le au moins un composé alcoolique ayant une solubilité dans l'eau et/ou le composé ayant au moins une liaison multiple carbone-hétéroatome et une liaison multiple hétéroatome-hétéroatome dans la molécule est introduit dans le revêtement des fines particules d'argent.

12. Pâte selon la revendication 11, dans laquelle la taille de particule moyenne des fines particules d'argent sont supérieures à 30 nm, la taille de particule moyenne étant mesurée en dispersant les fines particules d'argent revêtues dans de l'octane, en déposant goutte à goutte cette dispersion sur un film de collodion (une grille de mailles de cuivre pour une observation au microscope électronique à transmission), en nettoyant avec du méthanol et en observant sur un microscope à balayage électronique à transmission (STEM) ou microscope électronique à balayage (SEM).
